**Europäisches Patentamt**

**European Patent Office**

**Office européen des brevets**

(19)

(11)  **EP 1 688 988 A1**

(12)  **EUROPEAN PATENT APPLICATION**
published in accordance with Art. 158(3) EPC

(43) Date of publication:
**09.08.2006 Bulletin 2006/32**

(51) Int Cl.:
*H01L 21/027* (2006.01)      *G03F 7/20* (2006.01)

(21) Application number: **04818466.7**

(22) Date of filing: **09.11.2004**

(86) International application number:
**PCT/JP2004/016584**

(87) International publication number:
**WO 2005/048325 (26.05.2005 Gazette 2005/21)**

(84) Designated Contracting States:
**AT BE BG CH CY CZ DE DK EE ES FI FR GB GR HU IE IS IT LI LU MC NL PL PT RO SE SI SK TR**

(30) Priority: **17.11.2003 JP 2003386572**

(71) Applicant: **NIKON CORPORATION**
**Tokyo 100-8331 (JP)**

(72) Inventor: **SHIBAZAKI, Yuichi,**
**NIKON CORPORATION**
**Chiyoda-ku,**
**Tokyo (JP)**

(74) Representative: **HOFFMANN EITLE**
**Patent- und Rechtsanwälte**
**Arabellastrasse 4**
**81925 München (DE)**

(54)  **STAGE DRIVE METHOD, STAGE APPARATUS, AND EXPOSURE APPARATUS**

(57)      A stage drive method for driving a stage on a surface of a surface plate along a guide part that extends in a first direction includes the step of rotating the guide part about an axis perpendicular to the surface based on a thrust occurring when the stage is driven in the first direction. It is possible to increase safety without causing gap collapse to occur even in the case where a moment load is applied to the guide part.

FIG. 2

**Description**

TECHNICAL FIELD

The present invention relates to a stage drive method, a stage apparatus, and an exposure apparatus, and it particularly relates to a stage drive method, a stage apparatus, and an exposure apparatus that are suitable for use when driving a stage held in a cantilever state.

BACKGROUND ART

In the past, various exposure apparatuses have been used in cases where semiconductor devices (integrated circuits) or liquid crystal display elements are manufactured by a lithography process. In recent years, in conjunction with higher integration of semiconductor elements, sequential movement type projection exposure apparatuses such as step and repeat system reduction projection exposure apparatuses (so-called steppers) and step and scan system scanning type projection exposure apparatuses that add improvements to such steppers (so-called scanning steppers) have become mainstream.

This type of projection exposure apparatus is mainly used as mass production equipment for semiconductor devices, etc., so it is an essential requirement that there be processing ability whereby a certain number of wafers can be exposure-processed in a certain period of time, that is, the throughput be increased.

In this type of projection exposure apparatus, three major operations are repeatedly performed using one wafer stage in the sequence: wafer exchange → alignment (search alignment, fine alignment) → exposure → wafer exchange. Therefore, if the aforementioned three operations, that is, a plurality of operations from among the wafer exchange, alignment, and exposure operations, can be simultaneously processed in parallel even partially, it would be possible to increase throughput compared to the case in which these operations are performed sequentially. However, exposure is not performed during wafer exchange and alignment. Therefore, so as to shorten the processing time, that is, to increase throughput, a method in which the stage that performs wafer exchange and alignment and the stage that performs exposure are simultaneously and independently controlled is conceivable.

In this regard, disclosed in Patent Document 1 (Japanese Published Unexamined Patent Application No. 2003-17404), for example, is a stage apparatus that is provided with a first guide bar and a second guide bar that are able to move in the Y axis direction by means of a Y axis linear motor and a first wafer stage and second wafer stage that are able to move in the X axis direction along the first guide bar and the second guide bar respectively, and that respectively independently drives the two wafer stages in parallel in the XY two-dimensional direction at an exposure position and an alignment position directly under a projection optical system and an alignment optical system arranged along the X axis direction.

In this stage apparatus, each of the wafer stages has a rough movement stage (stage main body), which is provided with air pads (gas static pressure bearings) and which is supported without contact on a guide bar leaving a minute gap by means of the static pressure of pressurized gas, and a fine movement stage (substrate table), which holds a substrate such as a wafer and is supported in a cantilever state with respect to the rough movement stage.

However, in the aforementioned prior art, the following problems exist.

When the wafer stage is driven by the linear motor in the X axis direction, in the case where the center of gravity of the wafer stage and the point of application of the driving force of the linear motor are misaligned, and in the case where the fine movement stage is supported on the rough movement stage in a cantilever manner, there is a possibility that a large moment load (yawing) is applied to the guide bar due to the inertial force of the wafer stage when the wafer stage is accelerated or decelerated by the driving of the linear motor. In this case, there is concern that, due to the large load, it will not be possible to maintain the gap in the air pads, so-called gap collapse will occur, and the guide bar and the rough movement stage will make contact, causing damage.

This problem is not limited to a configuration in which a plurality of stages is provided; there is a possibility that it will occur in the same way even in the case where a single stage is provided.

DISCLOSURE OF INVENTION

The present invention was devised taking the above points into account, and its purpose is to provide a stage drive method, a stage apparatus, and an exposure apparatus that are able to increase safety without causing gap collapse to occur even in the case where a moment load is applied to the guide part.

In order to achieve the above purpose, the present invention employs the following configurations.

The stage drive method of the present invention is a method that drives a stage on the surface of a surface plate along a guide part that extends in a first direction, and the method includes a step that rotates the guide part about an axis that is perpendicular to the surface according to a thrust occurring when the stage is driven in the first direction.

In addition, the stage apparatus of the present invention is an apparatus that drives a stage on the surface of a surface plate along a guide part that extends in a first direction, and the apparatus has a rotary drive apparatus that rotates and drives the guide part about an axis that is perpendicular to the surface according to a thrust occurring when the stage is driven in the first direction.

Therefore, in the stage drive method and the stage apparatus of the present invention, in the case where a load corresponding to the thrust occurring when the stage is driven in the first direction is applied to the guide part, it is possible to absorb the load as a counter mass by rotating the guide part in the direction in which the load is applied without opposing that load. For this reason, it is also possible to restrict the occurrence of damage, etc. without causing gap collapse between the stage and the guide part.

Also, the exposure apparatus of the present invention is an apparatus for exposing a substrate held on a substrate stage with a pattern of a mask held on a mask stage, and has a stage apparatus as described above is used as at least one of the mask stage and the substrate stage.

Therefore, with the exposure apparatus of the present invention, it is possible to restrict the occurrence of damage, etc. without causing gap collapse to occur even in the case where a load corresponding to the thrust occurring when the mask stage or the substrate stage is driven is applied to the guide part in exposure processing.

In the present invention, it is possible to reduce the load applied to the air pads to prevent gap collapse from occurring, so it is possible to improve the safety of the apparatus.

BRIEF DESCRIPTION OF THE DRAWINGS

FIG. 1 is a drawing that schematically shows an exposure apparatus of an embodiment of the present invention.

FIG. 2 is a perspective view that schematically shows the stage apparatus of FIG. 1 along with the projection optical system and the alignment system.

FIG. 3 is a perspective view that shows the stage apparatus in a state in which the interferometer system and the wafer stage have been removed from the state in FIG. 2.

FIG. 4A is a perspective view that shows an enlargement of the fork part of the stage apparatus, and FIG. 4B is a perspective view that shows an enlargement of the wafer stage.

FIG. 5 is a perspective view that shows an enlargement of the state in which the wafer stage has been joined to the fork part.

FIG. 6 is a control block diagram that shows the principal configuration of the control system of the exposure apparatus.

FIG. 7A is a drawing that explains the operation of the wafer stage and the Y stage, and FIG. 7B is a drawing that similarly explains the operation of the wafer stage and the Y stage.

FIG. 8 is a drawing that shows the relationship between time and the thrust in the X axis direction and the input torque.

FIG. 9 is a drawing that shows a modeled spring mass system.

FIG. 10A is a drawing for explaining the flow of parallel processing between the exposure operation and the alignment operation, FIG. 10B is a drawing that is similarly for explaining the flow of the aforementioned parallel processing, and FIG. 10C is also a drawing for explaining the flow of the aforementioned parallel processing.

FIG. 11A is also a drawing for explaining the flow of the aforementioned parallel processing, FIG. 11B is also a drawing for explaining the flow of the aforementioned parallel processing, and FIG. 11 C is also a drawing for explaining the flow of the aforementioned parallel processing.

FIG. 12A is also a drawing for explaining the flow of the aforementioned parallel processing, and FIG. 12B is also a drawing for explaining the flow of the aforementioned parallel processing.

FIG. 13 is a drawing that shows the relationship between time and the thrust in the X axis direction and the input torque.

FIG. 14A is a drawing that explains the operation of the wafer stage and the Y stage, and FIG. 14B is a drawing that similarly explains the operation of the wafer stage and the Y stage.

FIG. 15 is a flow chart that shows an example of the semiconductor device fabrication process.

BEST MODE FOR CARRYING OUT THE INVENTION

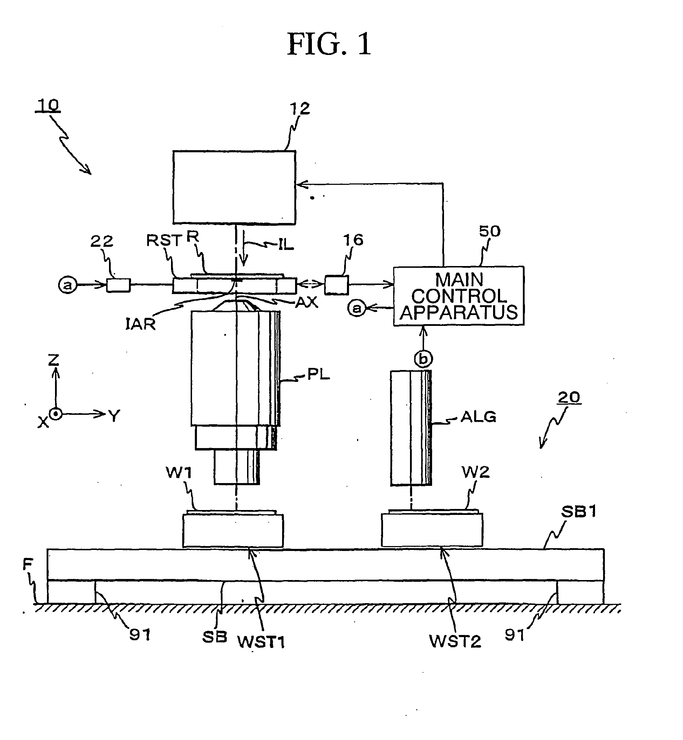

Embodiments of the stage drive method, the stage apparatus, and the exposure apparatus of the present invention will be explained below while referring to FIG. 1 through FIG. 15.

Also, in the embodiments, an explanation will be given using an example of the case in which the stage apparatus relating to the present invention is applied to a wafer stage (i.e., a stage apparatus 20 discussed below).

First Embodiment

The exposure apparatus 10 of an embodiment is schematically shown in FIG. 1.

This exposure apparatus 10 is a step and scan system scanning type exposure apparatus, a so-called scanning stepper, which simultaneously moves a reticle R as the mask and a wafer W 1 (or W2) as the substrate (photosensitive substrate) in a one-dimensional direction (here, the Y axis direction, which is the left and right direction of the surface of the page in FIG. 1) and transfers the circuit pattern (pattern) formed on the reticle R to each of a plurality of shot regions on the wafer W 1 (or W2) via a projection optical system PL.

The exposure apparatus 10 has an illumination system 12, which illuminates a reticle R using illumination light IL as an energy beam, a reticle stage RST as a mask stage on which the reticle R is mounted, a projection optical system PL, which projects the illumination light IL radiated from the reticle R onto a wafer W 1 (or W2), a stage apparatus 20 that includes two stages on which wafers W1 and W2 are respectively mounted, that is, wafer stages WST1 and WST2, an alignment system ALG as a mark detection system, and a main control apparatus 50, which comprehensively controls the entire apparatus.

The stage apparatus 20 has a stage surface plate (surface plate) SB arranged below the projection optical system PL in FIG. 1, wafer stages (stages) WST1, WST2 that independently move within the XY two-dimensional plane along the surface (upper surface) SB1 of the stage surface plate SB, and the drive system that drives these wafer stages WST1, WST2.

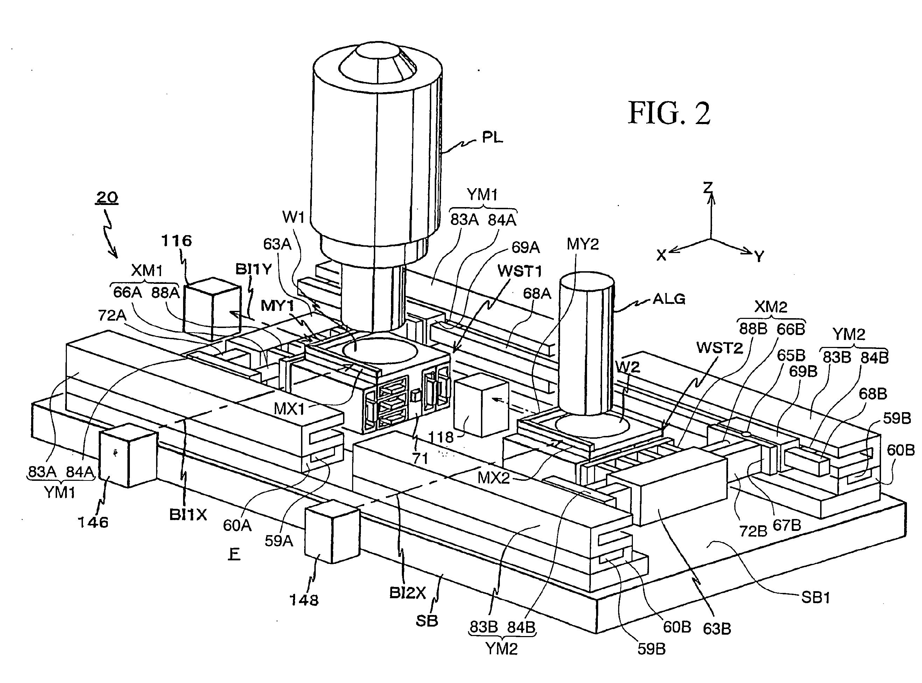

The stage surface plate SB has a rectangular shape in a planar view (see FIG. 2), and it is supported approximately horizontally (parallel to the XY plane) via a plurality of (for example, three) vibration damping units 91 (where the vibration damping unit at the back side of the surface of the paper in FIG. 1 is not shown in the drawing) on a floor surface F within a clean room. In this case, minute vibrations transmitted from the floor surface F to the stage surface plate SB are insulated at the micro G level (G is the gravitational acceleration) by the plurality of vibration damping units 91.

Note that, for the respective vibration damping units, it is possible to use so-called active vibration damping apparatuses which respectively actively damp the stage surface plate SB based on the output of vibration sensors such as semiconductor accelerometers that are respectively fastened to prescribed locations of the stage surface plate SB.

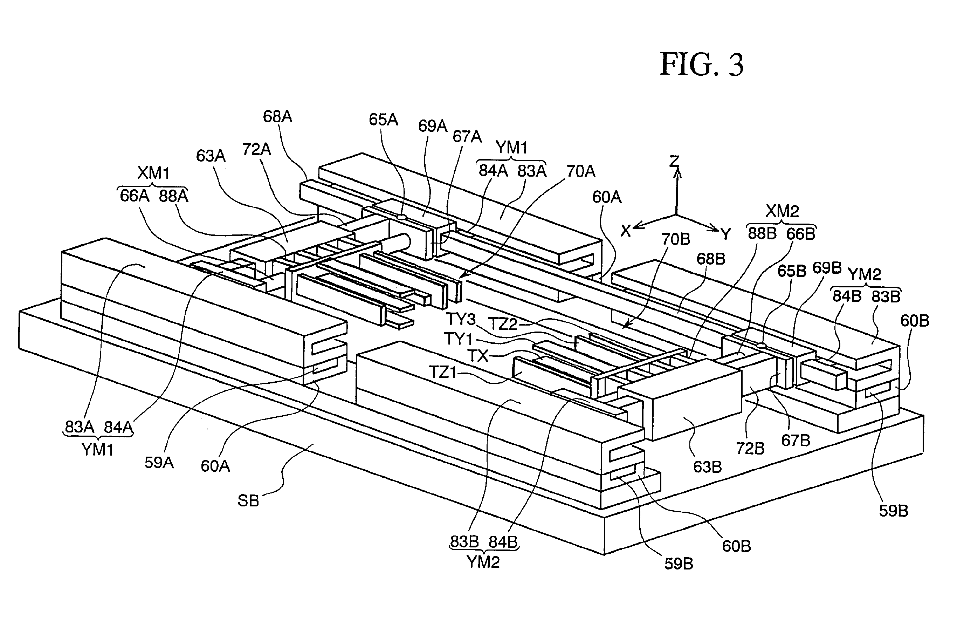

In FIG. 2, the stage apparatus 20 is schematically shown in a perspective view along with the projection optical system PL, the alignment system ALG, etc. In addition, the remaining parts of the stage apparatus 20 in a state in which the interferometer system (116, 118, 146, 148) and the wafer stages WST1, WST2 have been deleted from the state of FIG. 2 are shown in a perspective view in FIG. 3. The respective constituent parts of the stage apparatus 20 will be explained below while referring primarily to FIG. 2 and FIG. 3 and to other drawings appropriately.

The drive system that drives the wafer stages WST1, WST2 mainly has X linear motors XM1, XM2, which respectively drive the wafer stages WST1, WST2 in the X axis direction (first direction), and Y linear motors (drive apparatuses) YM1, YM2, which respectively drive the wafer stages WST1, WST2 in the Y axis direction (second direction).

As shown in FIG. 3, the Y linear motor YM 1 has stators 83A, 83A arranged as a pair along the Y axis direction at both end parts of the X axis direction of the stage surface plate SB and movers 84A, 84A driven in the Y axis direction along the stators 83A, 83A by means of electromagnetic interaction with the respective stators 83A, 83A.

Each of the respective stators 83A is supported on the stage surface plate SB via a support member 59A and a Y guide 60A which extend in the Y direction (where the support member 59A of the -X side is not shown in the drawing). Each support member 59A is provided on the lower surface (the -Z side surface) of the relevant stator 83A, and has an air bearings such as an air pad, and engages with the relevant Y guide 60A without contact in the Y axis direction so that each support member 59A is able to move freely.

In addition, the reaction force that accompanies movement of the movers 84A, 84A (or the wafer stage WST1 or WST2) in the Y axis direction is absorbed by the movement of the stators 83A, 83A along the Y guides 60A, 60A; thus, the momentum applied to the stage surface plate SB becomes zero theoretically, and the position of the center of gravity on the stage apparatus 20 is effectively fixed in the Y direction.

In the same way, the Y linear motor YM2 has stators 83B, 83B arranged as a pair along the Y axis direction at both end parts of the X axis direction of the stage surface plate SB and the movers 84B, 84B driven in the Y axis direction along the stators 83B, 83B by means of electromagnetic interaction with the respective stators 83B, 83B.

Each of the respective stators 83B is supported on the stage surface plate SB via a support member 59B and a Y guide 60B which extend in the Y direction. Each support member 59B is provided on the lower surface (the -Z side surface) of the stator 83B and has an air bearings such as an air pad, and engages with the relevant Y guide 60B without contact in the Y axis direction so that each support member 59B is able to move freely.

In addition, the reaction force that accompanies movement of the movers 84B, 84B (or the wafer stage WST2 or WST1) in the Y axis direction is absorbed by the movement of the stators 83B, 83B along the Y guides 60B, 60B; thus, the momentum applied to the stage surface plate SB becomes zero theoretically, and the position of the center of gravity on the stage apparatus 20 is effectively fixed in the Y direction.

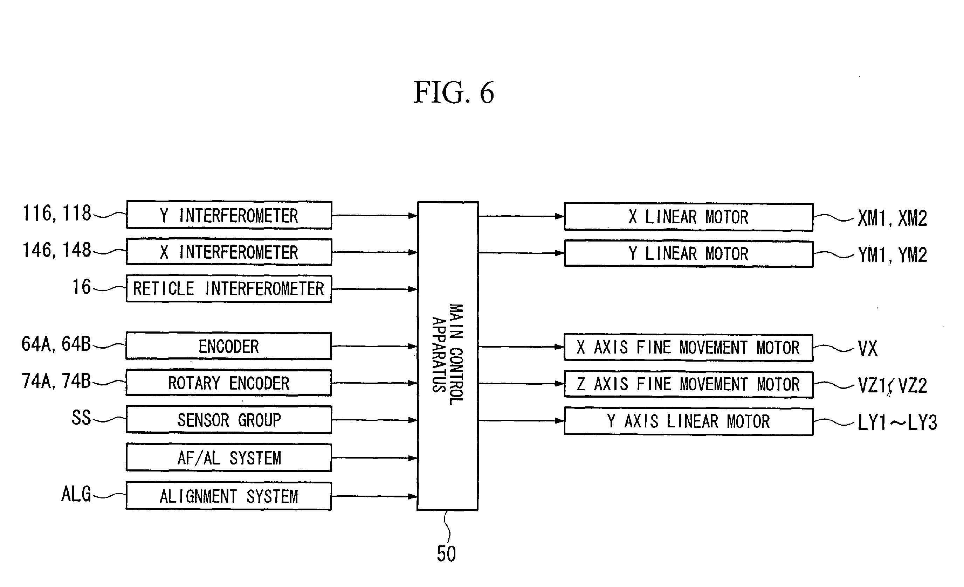

In addition, guide parts 68A, 68B that extend in the Y axis direction are respectively provided in the vicinity of the stators 83A, 83B positioned on the -X side of the stage surface plate SB, and Y sliders 69A, 69B that engage with the guide parts 68A, 68B to guide movement in the Y axis direction are respectively provided at the movers 84A, 84B positioned on the -X side. Encoder scales, which are used when the positions of the Y sliders 69A, 69B in the Y axis direction are measured are formed on the guide parts 68A, 68B. In addition, encoders (encoder heads) 64A, 64B, which measure the encoder scales, are provided on the Y sliders 69A, 69B, and the measured position information is output to the main control apparatus 50 (See FIG. 6).

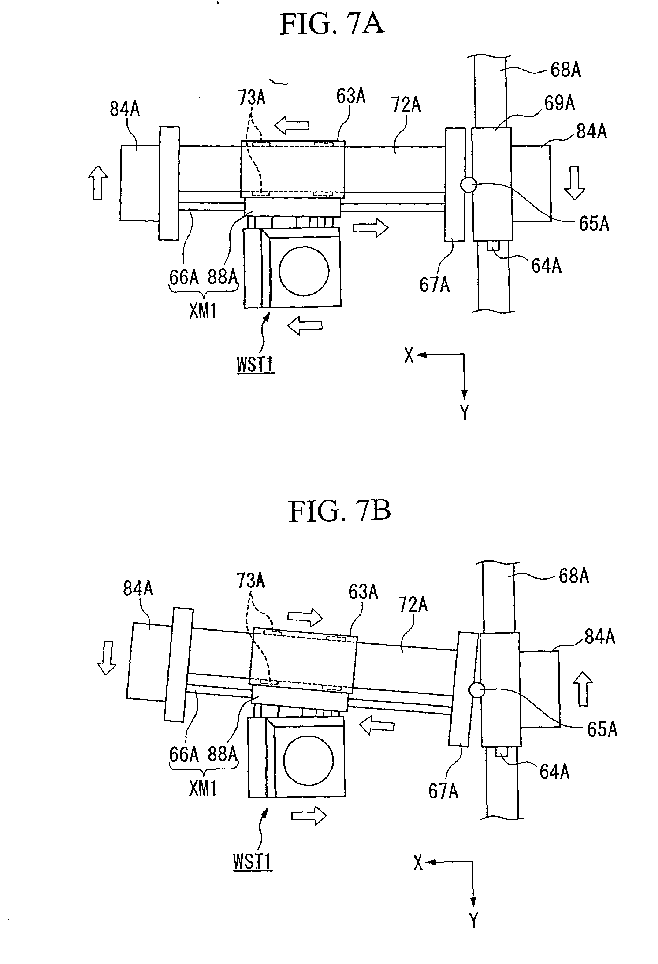

X linear motor XM1 has a stator 66A, which is built along the X direction and whose both ends are fastened to attachment plates 67A, 67A, and a mover 88A driven in the X axis direction along the stator 66A by means of electromagnetic interaction with the stator 66A. In addition, a Y stage (guide member) 72A that extends in the X axis direction in parallel with the stator 66A is built between the attachment plates 67A, 67A. This Y stage 72A guides the X rough movement stage 63A that moves in unison with the mover 88A. The X rough movement stage 63A has a rectangular framework shape in cross section, it surrounds the four surfaces (the top and bottom surfaces and both side surfaces) of the Y stage 72A, and it is able to move without contact via a plurality of air pads 73A (see FIG. 7A and FIG. 7B), which are gas static pressure bearings (non-contact bearings). These air pads 73A are arranged to oppose the respective four surfaces of the Y stage 72A and leave gaps in the X axis direction at the respective surfaces.

The attachment plate 67A positioned on the +X side is integrally attached to the mover 84A of the Y linear motor YM 1, and the attachment plate 67A positioned on the -X side is linked to the mover 84A (Y slider 69A) via a linking member 65A. The linking member 65A has a radial bearing, etc., and the Y stage 72A and the mover 84A (Y slider 69A) are connected so that they are able to rotate freely about an axis perpendicular to the surface of the stage surface plate SB (about an axis parallel to the Z axis) via an attachment plate 67A. The positional relationship between this Y stage 72A and the mover 84A (i.e., the Y slider 69A) in the θZ direction is measured by a rotary encoder 74A, and that measurement result is output to the main control apparatus 50 (see FIG. 6).

In the same way, the X linear motor XM2 has a stator 66B, which is built along the X direction and whose both ends are fastened to attachment plates 67B, 67B, and the mover 88B that is driven in the X axis direction along the stator 66B through electromagnetic interaction with the stator 66B. In addition, a Y stage (guide part) 72B that extends in the X axis direction in parallel with the stator 66B is built between the attachment plates 67B, 67B. This Y stage 72B guides the X rough movement stage 63B that moves in unison with the mover 88B. In the same way as the X rough movement stage 63A, the X rough movement stage 63B has a rectangular framework shape in cross section, it surrounds the four surfaces (the top and bottom surfaces and both side surfaces) of the Y stage 72B, and it is able to move without contact via a plurality of air pads, which are gas static pressure bearings (non-contact bearings). Note that the air pads in the X rough movement stage 63B are omitted from the drawing, but they are provided in the same arrangement as the air pads 73A of X rough movement stage 63A.

The attachment plate 67B positioned on the +X side is integrally attached to the mover 84B of the Y linear motor YM2, and the attachment plate 67B positioned on the -X side is linked to the mover 84B (i.e., the Y slider 69B) via a linking member 65B. The linking member 65B has a radial bearing, etc., and the Y stage 72B and the mover 84B (i.e., the Y slider 69B) are connected via the attachment plate 67B so that they are able to rotate freely about an axis perpendicular to the surface of the stage surface plate SB. The positional relationship between this Y stage 72B and the mover 84B (i.e., the Y slider 69B) in the θZ direction is measured by a rotary encoder 74B, and that measurement result is output to the main control apparatus 50 (see FIG. 6).

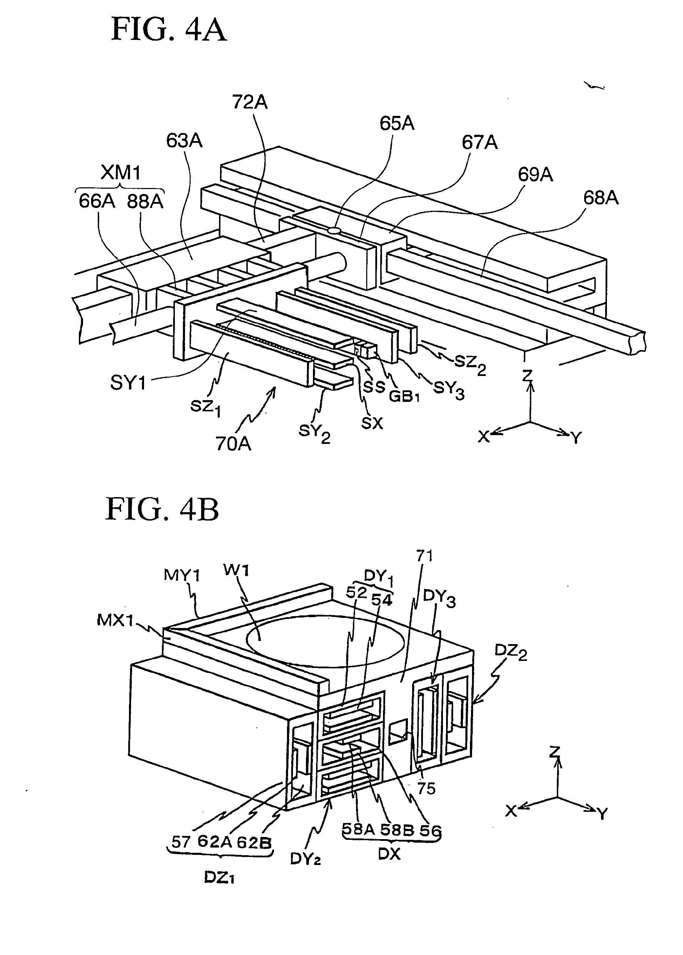

As shown in FIG. 3, a fork part 70A that includes a stator group that extends in the Y axis direction is supported in a cantilever state on the side surface of the +Y side of the mover 88A. In the same way, a fork part 70B that includes a stator group that extends in the Y axis direction is supported in a cantilever state on the side surface of the -Y side of the mover 88B. To explain these in detail, as shown in an enlarged manner in FIG. 4A, one of the fork parts 70A has six stators SX, SY1, SY2, SY3, SZ1, SZ2 and a guide bar GB 1.

The stator SX has an armature coil inside, and it is arranged with the Y axis direction as the lengthwise direction so that it is nearly parallel to the XY plane. The stators SY1, SY2 have armature coils inside, and they are arranged to be nearly parallel leaving respective prescribed gaps above and below the stator SX. The stator SY3 has an armature coil inside, and it is arranged on the -X side at a position that leaves a prescribed gap from the stators SX, SY 1 and SY2. The stators SZ1 and SZ2 have armature coils inside, and they are respectively arranged on the +X side of the stators SX, SY1, and SY2 and on the -X side of the stator SY3. The guide bar GB 1 consists of a square-column-shaped member in which one end in the lengthwise direction thereof is connected to the mover 88A, and a sensor group SS is embedded in the vicinity of the other end part (front end part) in the lengthwise direction as a detection apparatus consisting of a plurality of electrostatic capacitance sensors. Through this sensor group SS, it is possible to measure the relative position of the wafer stage WST1 and the fork part 70A in the X axis and the Z axis directions and in the θX, θY and θZ directions (to be discussed below).

Returning to FIG. 3, the other fork part 70B is also provided on the -Y side surface of the mover 88B in the same way as the fork part 70A. This fork part 70B is provided with six stators TX, TY1, TY2, TY3, TZ1, TZ2 and a guide bar GB2 (the guide bar GB2 is not shown in FIG. 3). These six stators TX, TY1, TY2, TY3, TZ1, TZ2 and the guide bar GB2 are such that one end in their respective lengthwise directions is fastened to the mover 88B in a symmetrical arrangement with the six stators SX, SY1, SY2, SY3, SZ1, SZ2 and the guide bar GB1 that form the fork part 70A. In this case, it is possible to arrange corresponding stators (specifically, the stators TX and SX, the stators TY1 and SY1, the stators TY2 and SY2, the stators TY3 and SY3, the stators TZ1 and SZ1, and the stators TZ2 and SZ2) and the guide bars GB1 and GB2 in mutual opposition, and the arrangement is such that it is possible to form one stator, etc. in the nearest state visually.

Note that an explanation of the details of the fork part 70B will be omitted, since the configurations of the corresponding stators and guide bars are completely similar.

As shown in FIG. 2, the wafer stage WST1 has a stage main body 71 in which the XZ cross-section is approximately T-shaped and a mover group integrally fastened to this stage main body 71 in the prescribed positional relationship, and it forms a rectangular shape overall. As shown in FIG. 4B, the mover group includes six movers DX, DY1, DY2, DY3, DZ1, DZ2. The movers DX, DY1 and DY2 correspond to the respective aforementioned stators SX, SY1 and SY2, and they are secured at the +X side and -Z side spaces of the stage main body 71 in a state in which they have been layered above and below each other in the sequence of the stators SY1, SX, and SY2 to correspond to the arrangement of these stators. In addition, the movers DY3 and DZ2 respectively correspond to the stators SY3 and SZ2, and they are secured at the -X side and -Z side spaces of the stage main body 71 in the sequence of the stators DY3 and DZ2 to correspond to the arrangement of these stators.

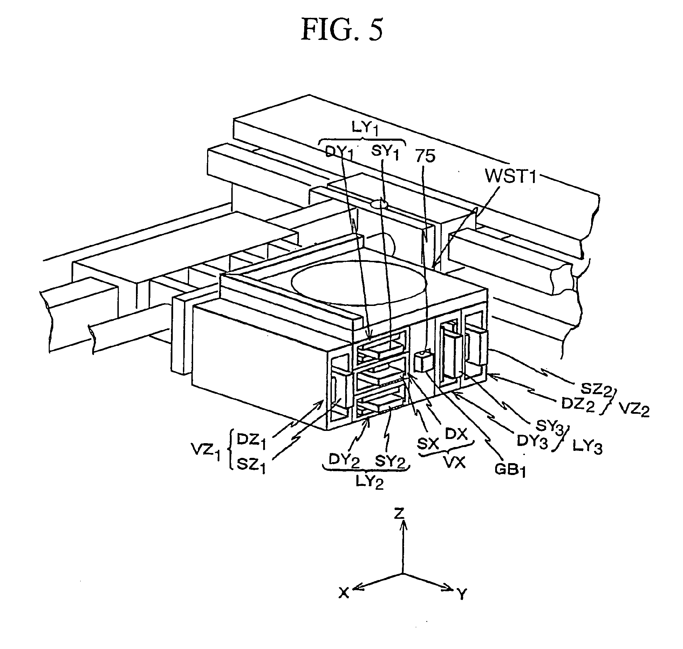

The mover DX has a frame-shaped member 56 consisting of a rectangular frame-shaped magnetic body and permanent magnets 58A, 58B which are respectively fastened to opposing surfaces (the upper surface and the lower surface) above and below at the inner side of the frame-shaped member 56 and extend in the Y axis direction. The permanent magnets 58A, 58B have mutually opposite polarities. In addition, as shown in FIG. 5, the stator SX is inserted between the permanent magnets 58A, 58B in a state in which the wafer stage WST1 and one of the fork parts 70A are linked, and the mover DX (and the wafer stage WST1) is driven by a small amount in the X axis direction with respect to stator SX by means of the electric current that flows through the armature coil of the stator SX and the Lorentz force generated by electromagnetic interaction with the magnetic field between the permanent magnets 58A, 58B. Specifically, an X axis fine movement motor VX that drives the wafer stage WST1 by a small amount in the X axis direction is formed by means of the stator SX and the mover DX.

The mover DY1 is arranged at the upper side of the mover DX, and it has a tube-shaped yoke 52 and a plurality of field magnets 54 that are respectively arrayed leaving a prescribed gap in the Y axis direction at opposing surfaces at the top and bottom of the inner side of the tube-shaped yoke 52. In this case, the field magnets 54 that are adjacent in the Y axis direction and the field magnets 54 that face each other in the Z axis direction have mutually opposite polarities. In addition, the stator SY1 is inserted into the interior space of the yoke 52 in a state in which the wafer stage WST1 shown in FIG. 5 and one of the fork parts 70A are linked, and a driving force in the Y axis direction acts on the mover DY1 by means of the electric current that flows through the armature coil of the stator SY 1 and the Lorentz force generated by electromagnetic interaction with the alternating magnetic field of the interior space of the yoke 52, and the mover DY1 is driven in the Y axis direction along the stator SY1. Specifically, in the present embodiment, a moving magnet type Y axis linear motor LY1 is configured by the stator SY1 and the mover DY 1.

The mover DY2 is arranged at the lower side of the mover DX, and its configuration etc. are the same as those of the mover DY2. Therefore, a driving force in the Y axis direction acts on the mover DY2 in a state in which the wafer stage WST1 shown in FIG. 5 and one of the fork parts 70A are linked, and the mover DY2 is driven in the Y axis direction along the stator SY2. Specifically, in the present embodiment, a moving magnet type Y axis linear motor LY2 is configured by the stator SY2 and the mover DY2.

The mover DY3 differs from the movers DY1 and DY2 in installation direction and size, but it is configured in the same way. Therefore, a driving force in the Y axis direction acts on the mover DY3 in a state in which the wafer stage WST1 shown in FIG. 5 and one of the fork parts 70A are linked, and the mover DY3 is driven in the Y axis direction along the stator SY3. Specifically, in the present embodiment, a moving magnet type Y axis linear motor LY3 is configured by the stator SY3 and the mover DY3.

In addition, in the present embodiment, the respective driving forces (thrusts) of the Y axis linear motors LY1 and LY2 are considered to be f, and the driving force of the Y axis linear motor LY3 is considered to be $2 \times f$, and it is possible to drive (drive nearly at the center of gravity) the wafer stage WST1 in the Y axis direction with respect to the fork part 70A. Also, in addition to it being possible to drive the wafer stage WST1 by a small amount in a rotation direction about the X axis (pitching direction) by making the driving forces generated by the Y axis linear motors LY1 and LY2 different, it is possible to drive the wafer stage WST1 by a small amount in a rotation direction about the Z axis (yawing direction) by making the resultant force (i.e., the sum) of the driving forces generated by the Y axis linear motors LY1 and LY2 different from the driving force generated by the Y axis linear motor LY3.

Note that, in the aforementioned way, in the present embodiment, it is possible to drive the wafer stage WST1 in the Y axis direction with respect to the fork part 70A by means of the driving forces generated by the aforementioned three Y axis linear motors LY1 to LY3, but during normal exposure, these Y axis linear motors LY1 to LY3 are used to drive the wafer stage WST1 by small amount in the Y axis direction, and the Y linear motor YM1 discussed above is used for rough driving relating to the wafer stage WST1 in the Y axis direction.

The mover DZ1 is provided on the +X side of the movers DX1, DY1, and DY2, and it has a frame-shaped member 57 in which XZ cross section consists of a rectangular frame-shaped magnetic body and a pair of permanent magnets 62A, 62B respectively provided on a pair of opposing surfaces ($\pm$X side surfaces) on the inner side of the frame-shaped member 57 and that extend in the Y axis direction. The permanent magnets 62A, 62B have mutually opposite polarities. In addition, the stator SZ 1 is inserted between the permanent magnets 62A, 62B in a state in which the wafer stage WST1 shown in FIG. 5 and one of the fork parts 70A are linked, and the mover DZ1 (and the wafer stage WST1) are driven by a small amount in the Z axis direction with respect to the stator SZ1 by means of the electric current that flows through the armature coil of the stator SZ1 and the Lorentz force generated by electromagnetic interaction with the magnetic field between the permanent magnets 62A, 62B. Specifically, a Z axis fine movement motor VZ1 that drives the wafer stage WST1 by a small amount in the Z axis direction is formed by means of the stator SZ1 and the mover DZ1.

The mover DZ2 is arranged on the -X side of the mover DY3, and its configuration is similar to that of the mover DZ1. In addition, a Z axis fine movement motor VZ2 which drives the wafer stage WST1 by a small amount in the Z axis direction is formed by the stator SZ2 and the mover DZ2 in a state in which the wafer stage WST1 shown in FIG. 5 and one of the fork parts 70A are linked.

In the present embodiment, in addition to it being possible to drive the wafer stage WST1 by a small amount in the Z axis direction by making the driving forces generated by Z axis fine movement motors VZ1 and VZ2 the same, it is possible to drive the wafer stage WST1 by a small amount in a direction of rotation (rolling direction) about the Y axis by making the driving forces of the respective Z axis fine movement motors different.

The amounts and directions of the electric currents supplied to the respective armature coils that form the aforementioned stators are controlled by the main control apparatus 50, and under the control of the main control apparatus 50, in the present embodiment, it is possible to drive the wafer stage WST1 by a small amount in a direction with six degrees of freedom with respect to the fork part 70A by means of the X axis fine movement motor VX, the Y axis linear motors LY1 to LY3, and the Z axis fine movement motors VZ1, VZ2. In addition, a through hole 75 is formed on the stage main body 71 along the Y axis direction, and the guide bar GB 1 is inserted into the through hole 75 in a state in which the wafer stage WST1 shown in FIG. 5 and one of the fork parts 70A are linked. As a result, it is possible to detect the relative positional relationship of the guide bar GB1 and the stage main body 71 with five degrees of freedom with the exception of the Y axis direction by means of the sensor group SS. The main control apparatus 50 adjusts the positional relationship of the guide bar GB 1 and the stage main body 71 by controlling the aforementioned respective motors as necessary based on the detection results of the sensor group SS.

Note that, in the present embodiment, in the aforementioned way, the six stators TX, TY 1, TY2, TY3, TZ1, TZ2 and the guide bar GB2, which form the fork part 70B, and the six stators SX, SY1, SY2, SY3, SZ1, SZ2 and the guide bar GB1, which form the fork part 70A, are respectively configured in the same way, and they have a symmetrical arrangement, so that the wafer stage WST1 can be linked in the same way as mentioned above from the opposite direction with respect to not only to the one fork parts 70A but to the other fork part 70B as well.

In this case, the mover DX and the stator TX, the mover DY1 and the stator TY 1, the mover DY2 and the stator TY2, the mover DY3 and the stator TY3, the mover DZ1 and the stator TZ1, and the mover DZ2 and the stator TZ2 of the wafer stage WST1 are respectively linked.

In addition, the wafer stage WST2 will not be discussed in detail, since it has a similar configuration to the wafer stage WST1, but it is such that attachment and removal with respect to either of the forks 70A, 70B are performed freely.

At the upper surface (the +Z side surface) of one of the wafer stages WST1, as shown in FIG. 2, a Y movable mirror MY1 that extends in the X axis direction is fastened to the end part of one side (-Y side) of the Y axis direction, and an X movable mirror MX1 that extends in the Y axis direction is fastened to the end part of one side (+X side) of the X axis direction. Interferometer beams (length measurement beams) from Y interferometer 116 and X interferometer 146 are respectively projected to the respective reflecting surfaces of the movable mirrors MY1 and MX1. In addition, by receiving the reflected light from the respective reflecting surfaces by means of the Y interferometer 116 and the X interferometer 146, displacement from the reference positions (in general, fixed mirrors are arranged at a side surface of the projection optical system and a side surface of the alignment system, and those are considered the reference surfaces) of the respective reflecting surfaces is measured, and this is used to measure the two-dimensional position of the wafer stage WST1.

Similarly, at the upper surface of the wafer stage WST2, a Y movable mirror MY2 that extends in the X axis direction is fastened to the end part of one side (-Y side) of the Y axis direction, and an X movable mirror MX2 that extends in the Y axis direction is fastened to the end part of one side (+X side) of the X axis direction. Interferometer beams (length measurement beams) from Y interferometer 118 and X interferometer 148 are respectively projected to the respective reflecting surfaces of the movable mirrors MY2 and MX2. Then, in the same way as described above, by receiving the reflected light from the respective reflecting surfaces by means of Y the interferometer 118 and X interferometer 148, the two-dimensional position of the wafer stage WST2 is measured.

Returning to FIG. 1, the illumination system 12 includes a light source and an illumination optical system, and illumination light IL is emitted as an energy beam to a rectangular or arc-shaped illumination area IAR specified by a field stop (masking blade or reticle blind) arranged in the interior thereof, and it illuminates a reticle R on which a circuit pattern is formed with even illumination. Here, for the illumination light IL, far ultraviolet irradiation such as KrF excimer laser light (wavelength of 248 nm) and ArF excimer laser light (wavelength of 193 nm) or vacuum ultraviolet light such as $F_2$ laser light (wavelength of 157 nm) is used.

A reticle R is fastened to the reticle stage RST, for example, by vacuum attraction. In addition to it being possible to drive the reticle stage RST by a small amount in the X axis direction, the Y axis direction, and the θZ direction (direction of rotation about the Z axis) within the XY plane perpendicular to the optical axis of the illumination system 12 (which matches optical axis AX of the projection optical system PL) by means of the reticle drive part 22, it is possible to drive it along the upper surface of a reticle stage surface plate (that is not shown in the drawing) at the scanning velocity designated for the prescribed scan direction (Y axis direction). Note that the reticle stage drive part 22 is a mechanism that uses a linear motor, a voice coil motor, etc. as the drive source, but in FIG. 1 it is shown as a simple block for convenience. Note that a rough and fine movement structure stage that has a rough movement stage that performs one-dimensional driving in the Y axis direction and a fine movement stage that is capable of driving the reticle R by a small amount in directions with at least three degrees of freedom (the X axis direction, the Y axis direction, and the θZ direction) with respect to the rough movement stage may also be employed as the reticle stage RST.

Note that the position of the reticle stage RST within the XY plane (including θZ rotation) is always detected by a reticle laser interferometer 16 (called the "reticle interferometer" hereinbelow) at a resolution of, for example, approximately 0.5 to 1 nm via a reflecting surface formed (or provided) on the reticle stage RST end part. Position information (including rotation information such as the θZ rotation amount (yawing amount)) of the reticle stage RST from the reticle interferometer 16 is output to the main control apparatus 50. At the main control apparatus 50, the reticle stage RST is driven and controlled via a reticle stage drive part 22 based on the position information of the reticle stage RST.

For the projection optical system PL, a reduction system in which both the object plane side (reticle side) and the image plane side (wafer side) are telecentric and whose projection magnification is 1/4 (or 1/5) is used. For this reason, when illumination light (ultraviolet pulsed light) IL is emitted from the illumination system 12 to the reticle R, the image forming luminous flux from the portion illuminated by the ultraviolet pulsed light in the circuit pattern region formed on the reticle R is incident on the projection optical system PL, and that circuit pattern image (partially-inverted image) within the illumination area IAR of that illumination light IL is restricted to a long, narrow slit shape (or rectangular (or polygon) shape) along the X axis direction at the center of the visual field of the image plane side of the projection optical system PL at each emission of the respective pulses of the ultraviolet pulsed light, and image formation is performed. Through this, the partially-inverted image of the projected circuit pattern is reduction-transferred to one of the resist layers in the plurality of shot regions on the wafer W 1 or W2 arranged on the image forming plane of the projection optical system PL.

Regarding the projection optical system PL, in the case where KrF excimer laser light or ArF excimer laser light is used as the illumination light IL, a refraction system consisting of only a refracting optical element (lens element) is mainly used, but in the case where $F_2$ laser light is used as the illumination light IL, a so-called catadioptric system (reflecting-refracting system), which combines a refracting optical element and a reflecting optical element (concave mirror, beam splitter, etc.) such as that disclosed in, for example, Japanese Published Unexamined Patent Application No. H3-282527 or a reflecting system consisting of only a reflecting optical element is used. However, in the case where $F_2$ laser light is used, it is possible to use a refracting system.

Returning to FIG. 1, on the +Y side of the projection optical system PL, an off-axis system alignment system ALC is installed at a position that is separated from the optical axis (nearly matches the center of projection of the reticle pattern image) of the projection optical system PL by a prescribed distance. This alignment system ALG has three types of alignment sensors, which are an LSA (Laser Step Alignment) system, an FIA (Field Image Alignment) system, and an LIA (Laser Interferometric Alignment) system, and it is able to perform X and Y two-dimensional direction position measurement of the reference marks on the reference mark plate and the alignment marks on the wafer. Here, the LSA system is the most general purpose sensor, which measures the mark position using light resulting from laser light being emitted to a mark and being diffracted and dispersed, and it has been conventionally used in a wide range of process wafers. The FIA system is a sensor that measures the mark position by illuminating the mark with broadband light such as a halogen lamp and image-processing this mark image, and it is effectively used on asymmetrical marks of the aluminum layer or the wafer surface. In addition, the LIA system is a sensor that emits laser light beams whose frequencies are slightly different to a diffraction grating mark and causes interference of the two generated diffracted lights to detect the mark position information from the phase thereof, and it is effectively applied to low steps and surface roughness wafers. In the present embodiment, each of these three types of alignment sensors is appropriately used according to the purpose, and so-called search alignment, which detects the positions of one-dimensional marks of three points on the wafer to perform overall position measurement of the wafer, and fine alignment, which performs accurate position measurement of the respective shot regions on the wafer, are performed.

In addition, though illustrations of these have been omitted in FIG. 1, autofocus/auto leveling measurement mechanisms (hereunder called "AF/AL systems") for finding out the focus position are respectively provided on the projection optical system PL and the alignment system ALG. A configuration of an exposure apparatus in which autofocus/auto leveling measuring mechanisms have been respectively provided on the projection optical system PL and the alignment system ALG in this way is disclosed in detail in, for example, Japanese Published Unexamined Patent Application No. H10-214783 and is commonly known, so further explanation will be omitted here. Therefore, in the present embodiment, in the same way as in the exposure apparatus described in Japanese Published Unexamined Patent Application No. H10-214783, it is possible to perform highly accurate alignment measurement by implementing autofocus/auto leveling by means of the same type of measurement and control of the AF/AL systems as during exposure during alignment sensor measurement by the alignment system ALG while performing alignment mark position measurement. In other words, an offset (error) resulting from the attitude of the stage is no longer generated between the time of exposure and the time of alignment.

The major configuration of the control system of the exposure apparatus 10 relating to the present embodiment is shown in FIG. 6. This control system has a main control apparatus 50 that comprehensively controls the entire apparatus, various measuring instruments that output measurement results to this main control apparatus 50, and various drive apparatuses that are driven based on these measurement results.

Note that, in the explanation below, descriptions with respect to points regarding the various drive apparatuses being driven by the control of the main control apparatus 50 are omitted.

To continue, operation of the stage apparatus 20 in the exposure apparatus 10 relating to the present embodiment will be explained. Note that operation of wafer stages WST1 and WST2 is similar, so an explanation will be given here using one of the wafer stages WST1 as an example.

When the wafer stage WST1 is moved in the Y axis direction by means of the exposure operation and the alignment operation, the main control apparatus 50 drives the Y linear motor YM 1 using a long stroke as it drives the Y axis linear motors LY 1 to LY3 by a small amount.

In addition, when the wafer stage WST1 is moved in the X axis direction by step movement, etc., the main control apparatus 50 drives the X linear motor XM1 using a long stroke as it drives the X axis fine movement motor VX by a small amount.

A moment load that corresponds to the thrust is applied to the X rough movement stage 63A by means of the inertial force of the wafer stage WST1, particularly at the time of acceleration or deceleration during movement of this wafer stage WST1 in the X axis direction. For example, as shown in FIG. 7A, when the mover 88A of the X linear motor XM1 is driven to the -X side during acceleration, an inertial force going to the +X side in relation to the wafer stage WST1 acts, so, as a result, a moment load is applied to the X rough movement stage 63A in a counterclockwise direction in relation to an axis parallel to the Z axis.

Here, the Y stage 72A is linked to the Y slider 69A so that it is able to rotate freely about an axis parallel to the Z axis by means of a linking member 65A; thus, the moment load that is applied to the X rough movement stage 63A is transmitted to the Y stage 72A via an air pad 73A, and the Y stage 72A rotates with the linking member 65A as the center of rotation. Specifically, the Y stage 72A functions as a counter mass with respect to the moment load generated in conjunction with the movement of the wafer stage WST1 in the X axis direction, so that the moment load that is applied to the X rough movement stage 63A (air pad 73A) is alleviated.

For example, when the inertia (inertial moment) of the X rough movement stage 63A is Ix, and the inertia of the Y stage 72A is Iy, the Y stage 72A functions as a counter mass and rotates, and the moment load that is applied to the air pad 73A is alleviated by $Iy/(Ix + Iy)$ times.

Similarly, during deceleration of the wafer stage WST1, as shown in FIG. 7B, an inertial force going to the -X side in relation to the wafer stage WST1 acts, so, as a result, a moment load is applied to the X rough movement stage 63A in a clockwise direction in relation to an axis parallel to the Z axis, but since rotation is performed with the linking member 65A as the center of rotation with the Y stage 72A as a counter mass, the moment load that is applied to the X rough movement stage 63A (the air pad 73A) is alleviated.

Note that, even in the case where the Y stage 72A and the X rough movement stage 63A have rotated due to acceleration and deceleration of the wafer stage WST1, the wafer stage WST1 has its position and attitude controlled by the driving of the X axis fine movement motor VX, the Y axis linear motors LY1 to LY3, and the Z axis fine movement motors VZ1, VZ2 based on the measurement results of the interferometers 116 and 146 under the control of the main control apparatus 50.

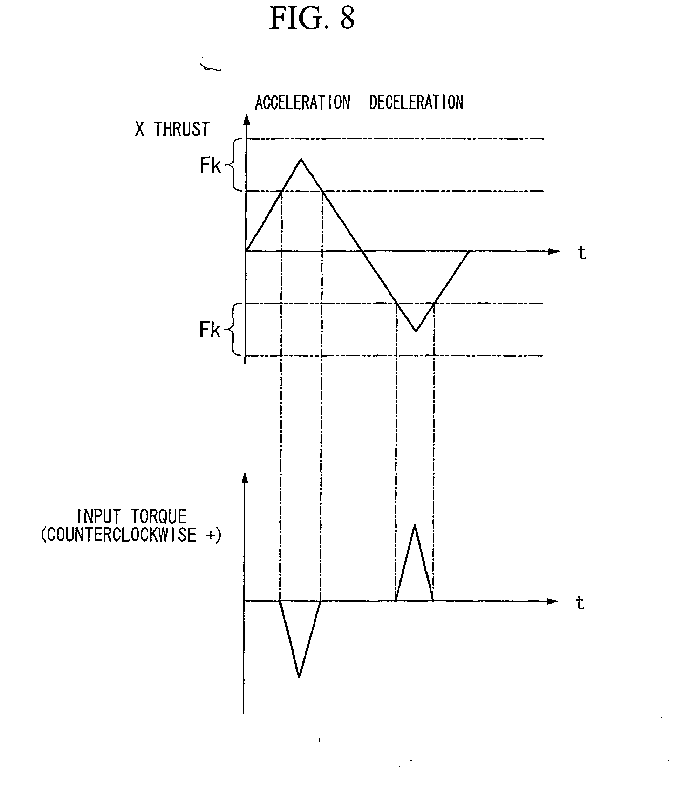

In addition, in such cases as when the tolerance of the air pad 73A is not reached even if the Y stage 72A functions as a counter mass and the moment load is alleviated, the main control apparatus 50 controls the movers 84A, 84A of the Y linear motor YM1 to drive them in a direction that would cause the load applied to the air pad 73A to escape. Specifically, when the X linear motor XM1 is driven by thrust in which the load applied to the air pad 73A is large and reaches the danger range Fk as in the graph of the upper part of FIG. 8 that shows the relationship between time and thrust in the X axis direction, the main control apparatus 50 drives the -X side mover 84A to the +Y side (that is, differentially moving the pair of the Y linear motors YM1, YM1) while monitoring the measurement results of the encoder 64A and the rotary encoder 74A so that rotation of the Y stage 72A is promoted when the thrust is in that range Fk and driving the +X side mover 84A of the Y linear motor YM1 to the -Y side during acceleration (so as to input torque).

Through this, the load applied to the air pad 73A is further alleviated, and it is also possible to set the load to zero by also adjusting the thrust of the movers 84A, 84A.

Note that, during deceleration, in contrast to during acceleration, when the thrust is within the range Fk, the -X side mover 84A is driven to the -Y side as the +X side mover 84A is driven to the +Y side in the Y linear motor YM1.

Here, the thrust (input torque) when driving the movers 84A, 84A to alleviate the load applied to the air pad 73A will be explained.

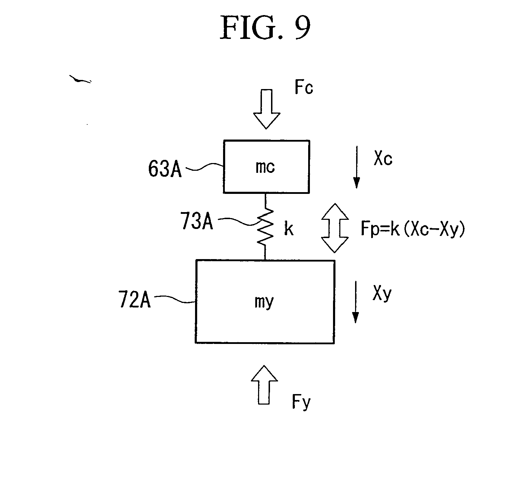

First, the rotational movement of the rough movement stage 63A and Y stage 72A accompanying the movement of the wafer stage WST1 can be modeled in the spring mass system shown in FIG. 9.

Specifically, in this spring mass system, the X rough movement stage 63A of mass mc and the Y stage 72A of mass my are linked via the air pad 73A as a constant k spring system. Then, if the displacement when a force Fc is applied to the rough movement stage 63A during driving of the wafer stage WST1 is Xc, and the displacement when the Y stage 72A is driven by a thrust Fy by means of the Y linear motor YM1 (the mover 84A) is Xy, the load Fp that is applied to the air pad 73A is expressed by the following expression.

$$Fp = k \times (Xc - Xy)$$

Here, if the transfer function of the force going from force Fc(s) to load Fp(s) is Gc(s), and the transfer function of the force going from thrust Fy(s) to load Fp(s) is Gy(s), the following expression is established.

$$Fp(s) = GC(s) \times Fc(s) + Gy(s) \times Fy(s) \dots (A)$$

Also, Gc(s), Fc(s), and Gy(s) are known, so the thrust Fy(s) of the mover 84A should be set based on the Expression (A) so that it becomes a value Fp(s) at which an excessive load will not be applied to the air pad 73A.

Note that if the mass of the rough movement stage 63A is mc, and the mass of the Y stage 72A is my, transfer function Gc(s) is indicated by Expression (B) below, and transfer function Gy(s) is indicated by Expression (C) below. In addition, at low frequencies, Expression (D) is derived from Expressions (A) to (C).

$$Gc(s) = \frac{my}{\dfrac{mc \times my}{k}s^2 + mc + my} \quad \cdots (B)$$

$$Gy(s) = \frac{mc}{\dfrac{mc \times my}{k}s^2 + mc + my} \quad \cdots (C)$$

$$Fp = \frac{my}{mc + my}Fc + \frac{mc}{mc + my}Fy \quad \cdots (D)$$

For example, as is clear from Expression (D), it is possible to set the load Fp that is applied to the air pad 73A to zero by driving the Y linear motor YM1 using a thrust in which Fy = (-my/mc) × Fc.

In addition, if the Y stage 72A functions only as a counter mass without driving the movers 84A, 84A, then Fy = 0, so the load Fp that is applied to the air pad 73A is expressed by Expression (E).

$$Fp = \frac{my}{mc + my} Fc \qquad \cdots (E)$$

Even in this case, as is clear from Expression (E), it is possible to alleviate the load Fp that is applied to the air pad 73A in comparison with the case where the Y stage 72A is not driven (Fp = Fc).

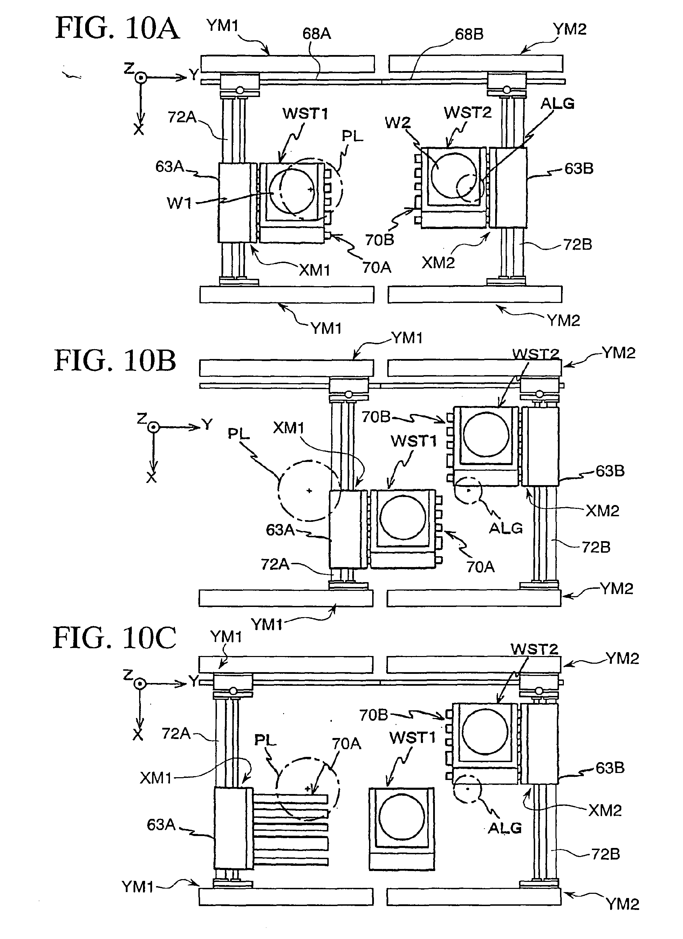

Next, a series of operations including parallel processing of the exposure operation and the alignment operation in the exposure apparatus 10 will be explained while referring to FIG. 10A through FIG. 12B.

In FIG. 10A, a state in which the wafer alignment operation with respect to the wafer W2 on the wafer stage WST2 is performed in parallel with the exposure operation with respect to the wafer W1 on the wafer stage WST1 being performed is shown.

When the wafer stage WST2 is in the prescribed rotating position in advance of the state of this FIG. 10A, unloading of the wafer for which exposure has been completed, which is mounted on the wafer stage WST2, and loading of a new wafer W2 onto the wafer stage WST2 (that is, wafer exchange) is performed by a wafer loader that is not shown in the drawing.

In addition, the main control apparatus 50 controls the position of the wafer stage WST2 within the XY plane based on the measurement values of the interferometers 118 and 148 (not shown in FIG. 10A to FIG. 10C; see FIG. 2) while detecting the position information of the alignment marks (sample marks) attached to a specific plurality of shot regions (sample shot regions) on the wafer W2 using the alignment system ALG.

Next, the main control apparatus 50 implements EGA (enhanced global alignment) system wafer alignment measurement that obtains the arrayed coordinates of all shot regions on the wafer W2 by means of a statistical computation that uses the method of least squares, which is disclosed in, for example, Japanese Published Unexamined Patent Application No. S61-44429, based on those detection results and the positional coordinates in the design of the specific shot regions. In addition, in this case, the main control apparatus 50 detects the position information of the first reference mark of the reference mark plate (not shown in the drawing) on the wafer stage WST2 before and after sample mark position detection. Then, the main control apparatus 50 converts the previously obtained arrayed coordinates of all of the shot regions on wafer W2 to position coordinates that have the position of the first reference mark as an origin.

Note that, during the aforementioned wafer exchange and wafer alignment, the main control system 50 drives the wafer stage WST2 using a long stroke by means of the X axis linear motor XM2 and the pair of the Y axis linear motors YM2, YM2 based on detection results from the interferometers 118 and 148 while driving the wafer stage WST2 by a small amount in relation to the X, Y, Z, θX, θY and θZ directions relative to the fork part 70B via the drive mechanism with six degrees of freedom discussed above. Note that the measurement results of the AF/AL systems discussed above are taken into account during driving in the Z, θX and θY directions.

In this way, wafer exchange and wafer alignment are performed on the wafer stage WST2 side. Performed in parallel with this wafer exchange and wafer alignment are, on the wafer stage WST1 side, a step and scan system exposure operation, which repeats an intershot stepping operation, which moves the wafer stage WST1 to an acceleration start position for exposing the respective shot regions on the wafer W1, which is mounted on the wafer stage WST1, based on the results of the wafer alignment that has already been performed, and a scanning exposure operation, which relatively scans the reticle R (reticle stage RST) and the wafer W 1 (the wafer stage WST1) in the Y axis direction to transfer a pattern formed on the reticle R to a shot region on the wafer W 1 via the projection optical system PL.

The main control apparatus 50 controls the position of the wafer stage WST1 based on the measurement results of the interferometers 116 and 146 (not shown in FIG. 10A to FIG. 10C; see FIG. 2) while measuring a second reference mark on a reference mark plate, which is not shown in the drawing, on the wafer stage WST1 and a reticle alignment mark on the reticle R using a reticle alignment system in advance of the start of the aforementioned step and scan exposure operation. Then, in the main control apparatus 50, the wafer stage WST1 is moved to the acceleration start position for exposure of the respective shot regions on the wafer W 1 based on those measurement results and the aforementioned wafer alignment results.

During the aforementioned step and scan system exposure operation, the main control apparatus 50 drives the wafer stage WST1 using a long stroke by means of the X axis linear motor XM1 and the pair of the Y axis linear motors YM1, YM1 while driving the wafer stage WST1 by a small amount in relation to the X, Y, Z, θX, θY and θZ directions relative to the fork part 70A via the drive mechanism with six degrees of freedom discussed above. Note that the measurement results of the AF/AL systems discussed above are taken into account during driving in the Z, θX and θY directions. In addition, the procedures of this exposure operation itself are similar to those of a normal scanning stepper, so a further detailed explanation will be omitted.

Of the wafer alignment operation with respect to the wafer W2 on the wafer stage WST2 and the exposure operation with respect to the wafer W1 on the wafer stage WST1, the wafer alignment operation normally ends first. Therefore, the main control apparatus 50 drives the wafer stage WST2 in the +Y direction and the -X direction via the X axis linear motor XM2 and the pair of the Y axis linear motors YM2, YM2 after the wafer alignment has ended. Then, the wafer stage WST2 is moved to a prescribed standby position (the position of the wafer stage WST2 shown in FIG. 10B), so as to be on standby in that position.

After that, when the exposure operation with respect to the wafer W 1 on the wafer stage WST1 has ended, the main control apparatus 50 moves the wafer stage WST1 in the +X direction and the +Y direction via the X axis linear motor XM1 and the pair of the Y axis linear motors YM1. The state after completion of this moving is shown in FIG. 10B.

Then, the main control apparatus 50 stops the supply of current to the respective stators of the fork part 70A that forms the aforementioned mechanism with six degrees of freedom on the wafer stage WST1 side. Through this, the supply of electric current to the stators SZ1, SZ2 of the Z axis fine movement motors VZ1, VZ2 is also stopped, the supporting force (driving force) that supports the wafer stage WST1 in the Z axis direction without contact is also released, and the wafer stage WST1 is mounted on the surface plate SB. From this state, the main control apparatus 50 moves the X axis linear motor XM1 and the fork part 70A in the -Y direction via the pair of the Y axis linear motors YM1. Through this, the wafer stage WST1 is released from the fork part 70A. In FIG. 10C, a state is shown in which movement of the X axis linear motor XM1 and the fork part 70A in the -Y direction ends and the wafer stage WST1 is released from the fork part 70A.

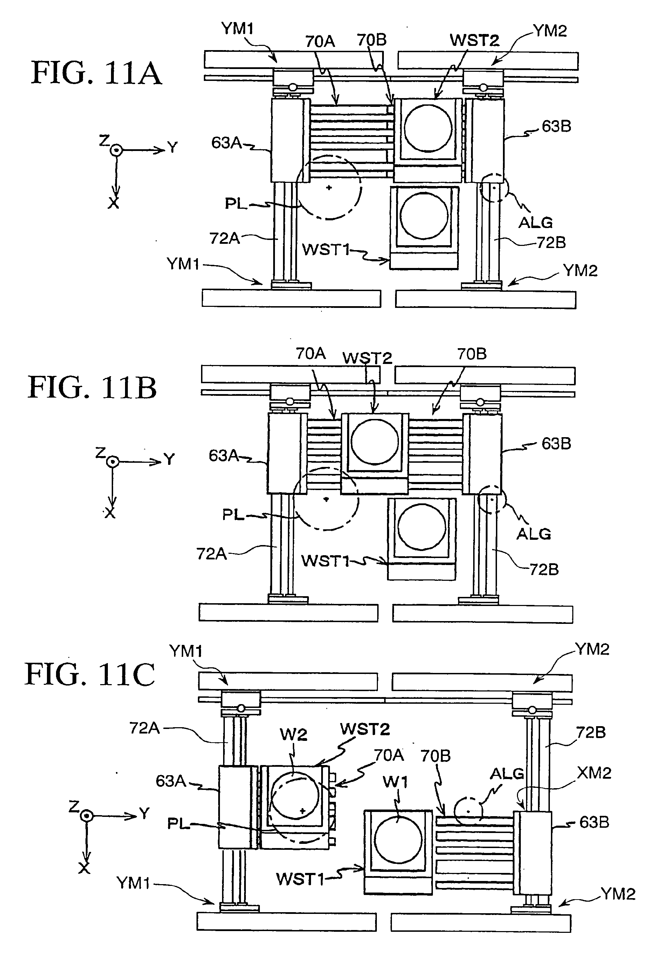

Next, the main control apparatus 50 moves the fork part 70A in the -X direction and the +Y direction in unison with the X rough movement stage 63A via the X axis linear motor XM1 and the Y axis linear motor YM1 while moving the X rough movement stage 63B, on which the fork part 70B is provided, in unison with the wafer stage WST2 in the -Y direction via the pair of the Y axis linear motors YM2. Then, as shown in FIG. 11A, the +Y side end part of the fork part 70A and the -Y side end part of the fork part 70B are brought as close together as possible (or into contact). Through this, the stators of the fork parts 70A and 70B and the guide bars are brought close to each other with a clearance of several μm to several mm and respectively appear to be linked as units.

Then, in a state in which the fork parts 70A and 70B are linked, the main control apparatus 50 sequentially supplies electric current to the respective armature coils of the stators TY1 to TY3 which form the fork part 70B and to the respective armature coils of the stators SY1 to SY3 that form the fork part 70A, and moves the wafer stage WST2 in the -Y direction with respect to the fork part 70B (or 70A).

Through this, the wafer stage WST2 is transferred from the fork part 70B to the fork part 70A. A state in which this wafer stage WST2 is in the process of being transferred is shown in FIG. 11B.

During the transfer (movement), the positional relationship of the wafer stage WST2 and the fork parts 70A and 70B is measured by the sensor group SS provided on the guide bars GB 1 and GB2; thus, even in the case where the positions of the fork parts 70A and 70B are somewhat misaligned from the prescribed positions, it is possible to perform transfer of the wafer stage WST2 from the fork part 70A to the fork part 70B without contact and at high speed by driving the wafer stage WST2 by a small amount (i.e., performing position adjustment of the stage) by means of the mechanism with six degrees of freedom.

Then, at the stage when the wafer stage WST2 has been completely transferred to the fork part 70A, the main control apparatus 50 controls the position of the wafer stage WST2 based on the measurement values of the interferometers 116 and 146 while measuring a pair of reference marks on a reference mark plate, which is not shown in the drawing, on the wafer stage WST2 and a pair of reticle alignment marks on the reticle R using the reticle alignment system discussed above. Then, in the main control apparatus 50, the wafer stage WST1 is moved to the acceleration start position for exposure of the first shot region on the wafer W2 based on those measurement results and the results of wafer alignment performed previously. After that, a step and scan exposure operation with respect to the wafer W2 is performed in the same way as the aforementioned exposure with respect to the wafer W1.

On the other hand, due to the end of the aforementioned transfer of the wafer stage WST2 from the fork part 70B to the fork part 70A, the main control apparatus 50 moves the fork part 70B, which is in a free state without linking to either of the wafer stages WST1 and WST2, in unison with the X rough movement stage 63B so that it approaches the wafer stage WST1, which is mounted on the surface plate SB, via the Y axis linear motor YM2 and the X axis linear motor XM2 (see FIG. 11C).

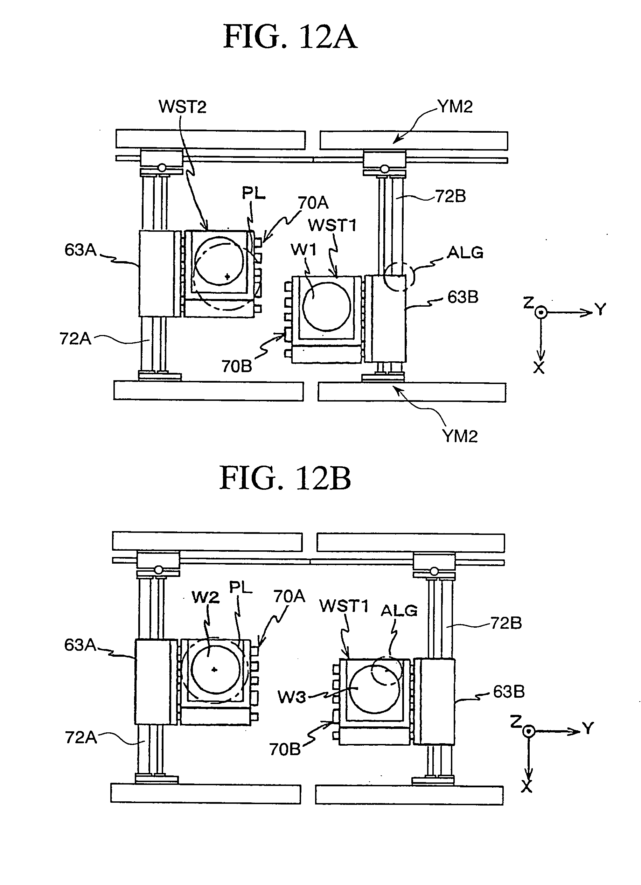

Then, from the state in FIG. 11C, in which the positions of the wafer stage WST1 and the fork part 70B in the X axis direction match, the main control apparatus 50 drives the fork part 70B in unison with the X rough movement stage 63B in the -Y direction via the Y axis linear motor YM2 so that the wafer stage WST1 and the fork part 70B are linked, and the state of FIG. 12A results. In this case, it is possible to detect the positional relationship of the guide bar GB2 and stage main body 71 via the sensor group positioned on the guide bar GB2 in a state in which the guide bar GB2 is inserted into the through hole 75 (see FIG. 4B) formed on the wafer stage WST1; thus, the main control apparatus 50 is able to drive the fork part 70B while adjusting the relationship between the wafer stage WST1 and the fork part 70B based on these detection results. In this way, at the stage when the wafer stage WST1 is linked with the fork part 70B, the main control apparatus 50 makes the Z axis motor for implementing the mechanism with six degrees of freedom generate driving force in the +Z direction, and it controls the driving force thereof so that the fork part 70B supports the wafer stage WST1 without contact.

After that, the main control apparatus 50 performs exchange of the wafer W1, for which exposure has been completed and which is mounted on the wafer stage WST1, for a wafer W3 subject to the next exposure (see FIG. 12B) and the wafer alignment operation of the wafer W3 is implemented in the same way as above.

In this way, in the exposure apparatus 10 of the present embodiment, the exposure operation with respect to the wafer on one wafer stage and the wafer exchange and wafer alignment operations on the other wafer stage are performed by simultaneous parallel processing while performing the wafer stage WST1 and WST2 exchange.

When wafer stages WST1 and WST2 have been moved in the X direction in this exposure operation and wafer exchange and wafer alignment operations, the Y stages 72A and 72B rotate according to the movement direction and acceleration thereof, and the moment load that is applied to the X rough movement stage 63A (the air pad 73A) is alleviated.

In the above way, in the present embodiment, even in the case where a moment load is applied to the Y stages 72A and 72B when wafer stages WST1 and WST2 move in the X axis direction, the Y stages 72A and 72B rotate with the linking members 65A and 65B as the center of rotation and function as a counter mass, so it is possible to reduce the load applied to the X rough movement stages 63A and 63B, that is, the air pads 73A and 73B. For this reason, in the present embodiment, it is possible to prevent gap collapse from occurring in the air pads 73A and 73B, so it is possible to avoid the X rough movement stages 63A and 63B and the Y stages 72A and 72B coming into contact and causing damage, and it is possible to improve the safety of the apparatus.

In addition, in the present embodiment, in the case where the load applied to the air pads 73A and 73B is large, the Y linear motors YM1 and YM2 are driven to promote rotation of the Y stages 72A and 72B, so it is possible to effectively alleviate the load applied to the air pads 73A and 73B, and it is possible to further increase the safety of the apparatus. Also, in the present embodiment, in order to make it possible to rotate the Y stages 72A and 72B, the linking members 65A and 65B are used to merely link with the stators 84A and 84B (the Y sliders 69A and 69B), and the Y linear motors YM1 and YM2 are merely differentially moved when the Y stages 72A and 72B are actively rotated. Therefore, it is possible to contribute to compactness and reduced cost of the apparatus without separately providing special apparatuses.

Second Embodiment

Next, a second embodiment relating to the stage drive method of the present invention will be explained.

In the aforementioned first embodiment, the load applied to the air pads 73A and 73B is reduced by rotating the Y stages 72A and 72B by differential movement of the Y linear motors, but in this method, in such cases as when the wafer stage is successively moved in the same direction, the rotation direction is also identical, so there is a possibility that the amounts of rotation are added together and the Y stages 72A and 72B will be considerably tilted.

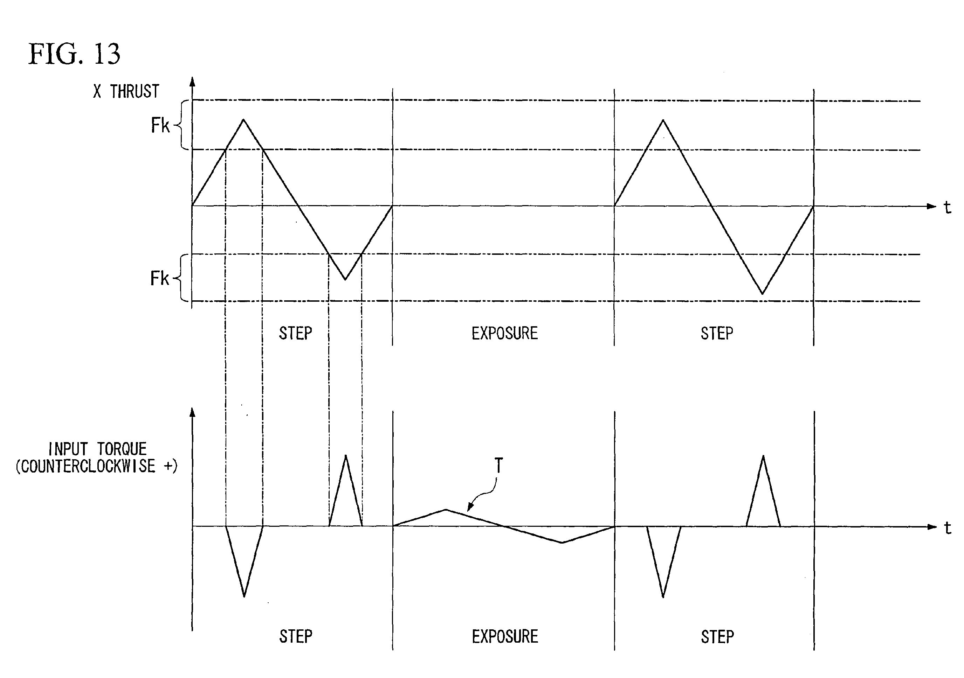

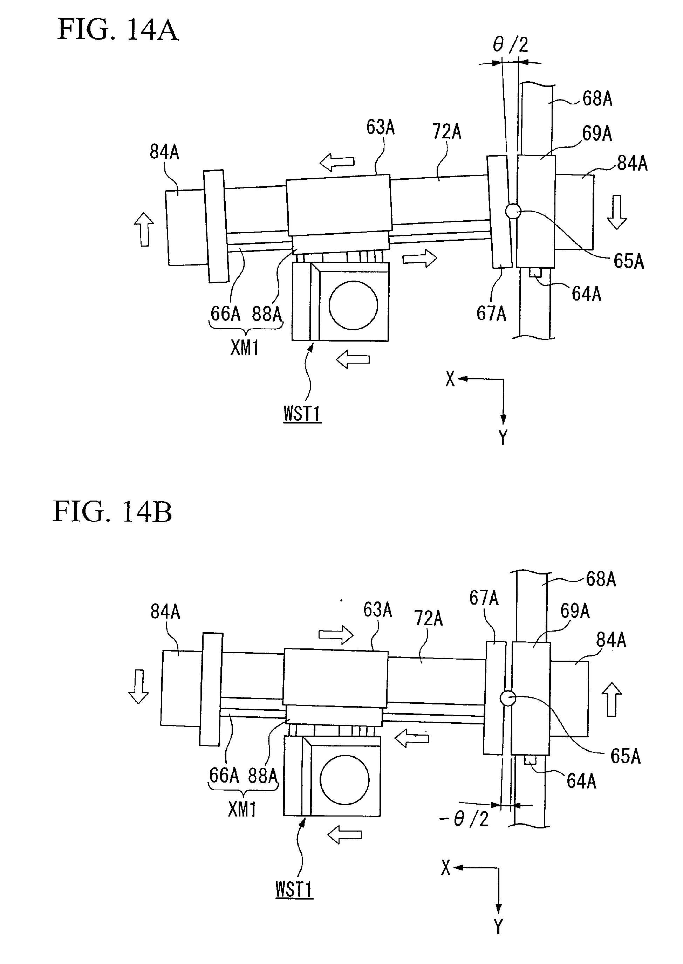

For this reason, in the present embodiment, the case in which a step that corrects the attitude of the Y stages 72A and 72B during exposure is provided will be explained while referring to FIG. 13 and FIGS. 14A and 14B.

In FIG. 13, in the graph of the upper side that shows the relationship between time and thrust in the X axis direction, a step process, in which wafer stages WST1 and WST2 move in the X axis direction, and an exposure process, in which (either of) wafer stages WST1 and WST2 simultaneously move in the Y axis direction along with the reticle R are alternately repeatedly performed. In this step process, as explained using FIG. 8, the main control apparatus 50 drives the Y linear motor in a differential movement state so that rotation of the Y stage is promoted when the X linear motor is driven by the thrust that reaches the danger range Fk where the load applied to the air pad becomes large.

In addition, in the exposure step, in which thrust is not applied to the wafer stage in the X axis direction, in other words, before the next step process (stage driving), the main control apparatus 50 drives the Y linear motor so that the Y stage is rotated in a rotation direction opposite to the rotation direction applied to the Y stage in the previous step. Changes over time in the input torque at this time resulting from the Y linear motor are shown in FIG. 13 and are indicated by reference symbol T in the graph at the bottom. As shown in this figure, Y stage attitude correction should be completed before the next step process; thus, the input torque is applied throughout the entire exposure step so that steep torque with a large absolute value is not applied.

Here, if the angle at which the Y stage rotates in one step process is $+\theta$ (the counterclockwise direction is considered to be the + direction), the main control apparatus 50 drives the Y linear motor prior to the step process to rotate the Y stage by $-\theta/2$. Specifically, the main control apparatus 50 causes rotation in advance of the step process in a direction opposite the direction in which the Y stage rotates due to step movement and at half the amount of the rotation angle generated by the step movement.

For example, as shown in FIG. 7, when the wafer stage WST1 step-moves in the -X axis direction, the Y stage 72A is rotated in a clockwise direction centering on linking member 65A. For this reason, the main control apparatus 50 rotates the Y stage 72A in a counterclockwise direction by an angle θ/2 prior to the step process, as shown in FIG. 14A. By doing this, after going through the step process, the Y stage 72A rotates in a clockwise direction at an angle θ, and as shown in FIG. 14B, goes into a state in which it is tilted by -θ/2 with respect to the X axis direction. Specifically, the Y stage rotates in an angular range of -θ/2 to +θ/2 with the X axis direction as a reference even when it has rotated at an angle θ in the step process.

In this way, in the present embodiment, the Y stage is rotated in the opposite direction prior to the step process to correct the attitude, so even in cases where step processes are successive, the rotations of the Y stage are not accumulated. In addition, in the present embodiment, Y stage attitude correction is implemented in the exposure process; thus, there is no longer a need to separately provide a process for performing correction, and it is possible to prevent drops in productivity.

Note that the aforementioned attitude correction of the Y stage does not necessarily need to be implemented during exposure if it is prior to the step process. In addition, even in the step process, the step process may be performed together with the Y stage attitude correction operation.

Also, in the aforementioned embodiments, an explanation was given with respect to a step process relating to the exposure operation in one of the stages. Also regarding the step process relating to wafer exchange and wafer alignment operations in the other stage (process of movement of the stage in the X axis direction), correction of the attitude of the Y stage prior to the next step movement may be performed when the Y stage has rotated due to the step movement of the wafer stage in the same way as during exposure operation, and causing rotation in the opposite rotation direction at an angle that is half the rotation amount generated in one step movement is particularly preferable.

In addition, in the aforementioned embodiments, the configuration is such that (the movers 84A and 84B of) the Y linear motors YM1 and YM2 move along the guide parts 68A and 68B, and the Y stages 72A and 72B are linked with the Y sliders 69A and 69B, which move in unison with the movers 84A and 84B, so that the Y stages are able to rotate freely about an axis parallel to the Z axis. However, it is not limited to this, and it is possible not to provide the guide parts 68A and 68B and the Y sliders 69A and 69B using a so-called guideless system. In this case, the movers 84A and 84B are respectively provided in a fixed state at both ends of the Y stages 72A and 72B, but as shown in FIG. 8 and FIG. 13, the relationship between the thrust of the wafer stage in the X axis direction and the torque applied to the Y linear motor according to this thrust is obtained in advance, and in the step process of the wafer stage, the main control apparatus 50 is able to reduce the load that is applied to the air pad in the same way as in the aforementioned first and second embodiments by differentially moving the pair of Y linear motors based on the relative positional relationship of the movers 84A and 84B and the Y stages 72A and 72B and the aforementioned obtained relationship.

Note that, in addition to radial bearings, it is also possible to use universal joints, elastic hinges, etc. as the linking members 65A and 65B in the aforementioned embodiment.

In addition, in the aforementioned embodiments, an explanation was given with a configuration in which the wafer stages WST1, WST2 are freely attached and removed (exchangeable) with respect to the X rough movement stages 63A, 63B, but it is not limited to this, and it is also possible to use a configuration in which, for example, the wafer stage WST1 and the X rough movement stage 63A, and the wafer stage WST2 and the X rough movement stage 63B, which are configured as units, are respectively independently moved to perform parallel processing of the exposure operation and the wafer exchange and alignment operations. In addition, the number of the wafer stages is not limited to two, and a configuration that uses only one stage or a configuration that uses three or more stages may be used.

In addition, in the aforementioned embodiments, the configuration was such that wafer stages WST1, WST2 are supported by a common stage surface plate SB so that they are able to move, but it is also possible to employ a two-surface-plate format in which they are supported by respectively independent surface plates.

In addition, in the aforementioned embodiments, the configuration was such that the stage apparatus of the present invention is applied to a wafer stage, but it may also be applied to a reticle stage RST.

In addition, in the present embodiment, the explanation concerned the case in which, while exposure is being performed on one of the wafer stages using one reticle pattern, wafer exchange, alignment, etc. are performed on the other wafer stage, but it is not limited to this, and as disclosed in, for example, Japanese Published Unexamined Patent Application No. 10-214783, it is possible to use a reticle stage that is capable of loading two reticles to perform dual exposure on one of the wafer stages using two reticle patterns while performing wafer exchange, alignment, etc. in parallel on the other wafer stage. When this is done, it is possible to achieve the effects of higher resolutions and improvement of the DOF (depth of focus) by means of dual exposure without much of a drop in throughput through simultaneous parallel processing.

Note that, in the aforementioned embodiments, an example was given of the case in which a stage apparatus relating to the present invention was applied to a scanning stepper, but the scope of applicability of the present invention is not limited to this, and the stage apparatus relating to the present invention can be appropriately applied to static type exposure apparatuses such as steppers that perform exposure in a state in which the mask and the substrate are made stationary as well. Even in such a case as this, it is possible to improve safety by means of the stage apparatus.

Of course the present invention can be applied not only to exposure apparatuses used in fabrication of semiconductor devices but also to exposure apparatuses that are used in the manufacture of displays including liquid crystal display elements, plasma displays, etc. and that transfer a device pattern onto a glass plate, exposure apparatuses that are used in the manufacture of thin film magnetic heads and that transfer a device pattern onto a ceramic wafer, and exposure apparatuses used in the manufacture of image sensors (CCDs).

In addition to fabrication of micro devices such as semiconductor devices, the present invention can also be applied to exposure apparatuses that transfer circuit patterns to glass substrates, silicon wafers, etc. in order to manufacture reticles or masks used in optical exposure apparatuses, EUV (extreme ultraviolet) exposure apparatuses, x-ray exposure apparatuses, and electron beam exposure apparatuses. Here, in exposure apparatuses that use DUV (deep ultraviolet) light or VUV (vacuum ultraviolet) light, in general, transmittance type reticles are used, and for the reticle substrate, silica glass, silica glass doped with fluorine, calcium fluorite, magnesium fluoride, or rock crystal are used. Also, in proximity system x-ray exposure apparatuses or electron beam exposure apparatuses, transmittance type masks (stencil masks, membrane masks) are used, and in EUV exposure apparatuses, a reflecting type mask is used, and a silicon wafer, etc. is used as the mask substrate.

In addition, the stage apparatus relating to the present invention is not limited to exposure apparatuses but can also be applied to other substrate processing apparatuses (for example, laser repair apparatuses, substrate inspection apparatuses, etc.) or sample positioning apparatuses in other precision equipment.

For the projection optical system PL, in the case where an ArF excimer laser light source or a KrF excimer laser light source is used as the light source, a refracting system consisting of only a refracting optical element (lens element) is mainly used, but in the case where an $F_2$ laser light source or an $Ar_2$ laser light source is used, a so-called catadioptric system (reflecting-refracting system), which combines a refracting optical element and a reflecting optical element (concave mirror or beam splitter, etc.), such as that disclosed in, for example, Japanese Published Unexamined Patent Application No. H3-282527, or a reflecting optical system that consists of only a reflecting optical element is mainly used. However, in the case where an $F_2$ laser light source is used, it is possible to use the refracting system.

In addition, in the aforementioned embodiments, the case in which a reduction system is used as the projection optical system was explained, but the projection optical system may be either a magnification system or an enlargement system. In addition, the reflecting-refracting type projection optical system is not limited to those described above, and, for example, a reduction system that has a circular image field and whose object plane side and image plane side are both telecentric while the projection magnification thereof is 1/4 times or 1/5 times may be used. In addition, in the case of a scanning type exposure apparatus that has this reflecting-refracting type projection optical system, it may be a type in which the region of emission of the illumination light is defined as a rectangular slit shape that extends along a direction that is nearly perpendicular to the scan direction of the reticle or the wafer within the visual field of the projection optical system with the optical axis thereof as nearly the center. Through a scanning type exposure apparatus having the relevant reflecting-refracting type projection optical system, it is possible to transfer fine patterns such as an approximately 100 nm L/S pattern onto the wafer with high accuracy even if $F_2$ laser light with a wavelength of 157 nm is used as the illumination light for exposure.

Also, the exposure optical system in the exposure apparatus relating to the present invention is not limited to a projection optical system, and it is also possible to use a charged particle beam optical system such as an x-ray optical system or an electron optical system. For example, if an electron optical system is used, the optical system may be configured to include an electron lens and a deflector, and it is possible to use thermionic emission type lanthanum hexaboride ($LaB_6$) or tantalum (Ta) for the electron gun. Note that it goes without saying that the optical path through which the electron beam passes is laid in a vacuum state.

In addition, in the case in which the present invention is applied to an exposure apparatus that uses an electron optical system, a configuration that uses a mask may be used, and a configuration that forms a pattern on a substrate by means of direct drawing by an electron beam without using a mask may also be used. Specifically, the present invention can be applied to any type from among a pencil beam system, a variable shaped beam system, a cell projection system, a blanking aperture system, or an EBPS as long as an electron beam exposure apparatus that uses an electron optical system is used as the exposure optical system.

In addition, in the exposure apparatus relating to the present invention, the exposure illumination light is not limited to the far ultraviolet band and vacuum ultraviolet band light discussed above, and soft x-ray range EUV light with a wavelength of approximately 5 to 30 nm may also be used. Also, for example, ArF excimer laser light, $F_2$ laser light, or the like is used as the vacuum ultraviolet light, but it is not limited to this, and a higher harmonic wave may be used in which infrared band or visible band single wavelength laser light oscillated from a DFB semiconductor laser or a fiber laser is amplified by a fiber amp that has been doped with erbium (or both erbium and yttrium) and wavelength-converted to ultraviolet light using a nonlinear optical crystal.

If the oscillation wavelength of a single wavelength laser is within a range of 1.51 to 1.59 $\mu$m, an 8x higher

harmonic wave in which the generated wavelength is within a range of 189 to 199 nm or a $10\times$ higher harmonic wave in which the generated wavelength is within a range of 151 to 159 nm is output. Particularly when the generated wavelength is within a range of 1.544 to 1.553 $\mu$m, an 8x higher harmonic wave in which the generated wavelength is within a range of 193 to 194 nm, that is, ultraviolet light of nearly the same wavelength as ArF excimer laser light, is obtained, and when the generated wavelength is within a range of 1.57 to 1.58 $\mu$m, a $10\times$ higher harmonic wave in which the generated wavelength is within a range of 157 to 158 nm, that is, ultraviolet light of nearly the same wavelength as $F_2$ laser light, is obtained.

In addition, when the oscillation wavelength is within a range of 1.03 to 1.12 $\mu$m, a 7x higher harmonic wave in which the generated wavelength is within a range of 147 to 160 nm is output, and particularly when the oscillation wavelength is within a range of 1.099 to 1.106 $\mu$m, a 7x higher harmonic wave in which the generated wavelength is within a range of 157 to 158 $\mu$m, that is, ultraviolet light of nearly the same wavelength as $F_2$ laser light, is obtained. In this case, it is possible to use, for example, an yttrium dope fiber laser as the single wavelength oscillation laser.

In the case where a linear motor is used in the substrate stage or the reticle stage as in the aforementioned embodiment, it is not limited to an air floating type that uses air bearings, and a magnetic levitation type that uses Lorentz's force may also be used.

The reaction force generated by the movement of the substrate stage may be caused to mechanically escape to the floor (ground) using a frame member as described in Japanese Published Unexamined Patent Application No. H8-166475. The reaction force generated by the movement of the reticle stage may be caused to mechanically escape to the floor (ground) using a frame member as described in Japanese Published Unexamined Patent Application No. H8-330224.

In the above way, the exposure apparatus of the present embodiment is manufactured by assembling various subsystems, including the respective constituent elements within the scope of the claims of the present application, so that the prescribed mechanical precision, electrical precision and optical precision are maintained. To ensure these respective precisions, performed before and after this assembly are adjustments for achieving optical precision with respect to the various optical systems, adjustments for achieving mechanical precision with respect to the various mechanical systems, and adjustments for achieving electrical precision with respect to the various electrical systems. The process of assembly from the various subsystems to the exposure apparatus includes mechanical connections, electrical circuit wiring connections, air pressure circuit piping connections, etc. among the various subsystems. Obviously, before the process of assembly from these various subsystems to the exposure apparatus, there are the processes of individual assembly of the respective subsystems. When the process of assembly to the exposure apparatuses of the various subsystems has ended, overall adjustment is performed, and the various precisions are ensured for the exposure apparatus as a whole. Note that it is preferable that the manufacture of the exposure apparatus be performed in a clean room in which the temperature, the degree of cleanliness, etc. are controlled.

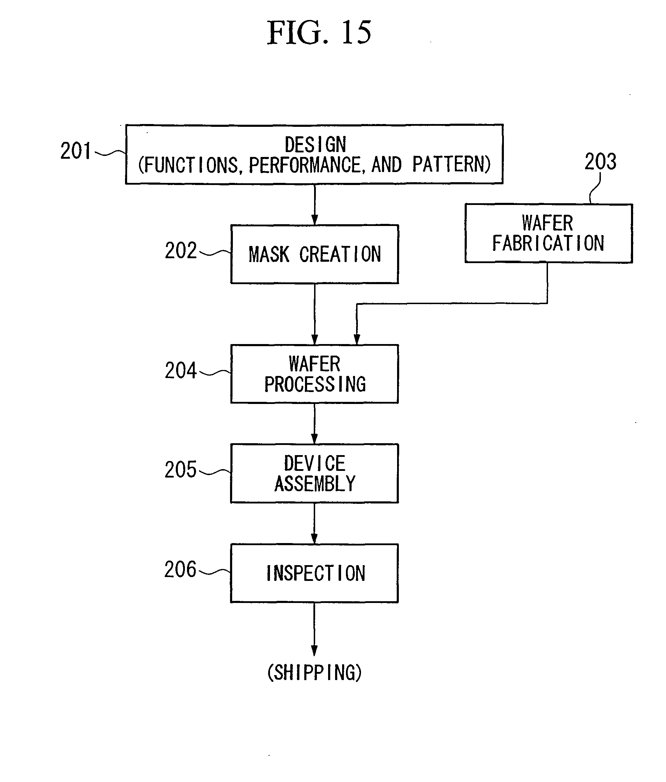

As shown in FIG. 15, semiconductor devices are manufactured by going through a step 201 that performs function and performance design of the device, a step 202 that creates the mask (or reticle) based on this design step, a step 203 that fabricates the substrate (or wafer) that is the device base material, a substrate processing step 204 that exposes the substrate with a pattern of the mask by means of the exposure apparatus EX of an embodiment discussed above, a device assembly step (including the dicing process, bonding process, and packaging process) 205, an inspection step 206, etc.

INDUSTRIAL APPLICABILITY

In the stage drive method and the stage apparatus of the present invention, in the case where a load that corresponds to the thrust is applied to the guide part when the stage is driven in a first direction, it is possible to absorb the load as counter mass by rotating the guide part in the direction in which the load is applied (the direction about an axis perpendicular to the surface of the surface plate) without opposing that load. For this reason, it is also possible to avoid causing gap collapse to occur between the stage and guide part and to also restrict the occurrence of damage, etc.

In addition, in the exposure apparatus of the present invention, even in the case where a load that corresponds to the thrust is applied to the guide part when the mask stage or the substrate stage is driven in exposure processing, it is also possible to avoid causing gap collapse to occur and to restrict the occurrence of damage, etc.

**Claims**

1.    A stage drive method for driving a stage on a surface of a surface plate along a guide part that extends in a first direction, comprising the step of:

rotating the guide part about an axis perpendicular to the surface based on a thrust occurring when the stage is driven in the first direction.

2. A stage drive method according to Claim 1, wherein:

   a pair of drive apparatuses that drive the guide part in a second direction that intersects the first direction are provided at both ends of the guide part, and
   the guide part is rotated about the axis by means of differential movement of the pair of the drive apparatuses.

3. A stage drive method according to Claim 2, further comprising the step of:

   detecting a relative positional relationship between at least one of the pair of drive apparatuses and the guide part.

4. A stage drive method according to Claim 1, further comprising the step of:

   rotating the guide part in a rotation direction that is opposite to the rotation direction about the axis prior to driving of the stage.

5. A stage drive method according to Claim 1, further comprising the step of:

   attaching the stage to and removing the stage from the guide part.

6. A stage apparatus that drives a stage on a surface of a surface plate along a guide part that extends in a first direction; comprising:

   a rotary drive apparatus that rotates and drives the guide part about an axis perpendicular to the surface based on a thrust occurring when the stage is driven in the first direction.

7. A stage apparatus according to Claim 6, further comprising:

   a pair of drive apparatuses that drive the guide part in a second direction that intersects the first direction are provided at both ends of the guide part, wherein
   the guide part is rotated about the axis by means of differential movement of the pair of drive apparatuses.

8. A stage apparatus according to Claim 6, wherein a plurality of the stages and a plurality of the guide parts are provided.

9. A stage apparatus according to Claim 6, wherein the stage is provided so that it is freely attached and removed with respect to the guide part.

10. A stage apparatus according to Claim 6, further comprising:

    a drive apparatus that rotates the guide part in a rotation direction that is opposite to the rotation direction about the axis when the stage does not move in the first direction.

11. A stage apparatus according to Claim 6, wherein the stage is a cantilever stage that is supported in a cantilever manner by the guide part.

12. An exposure apparatus for exposing a substrate held on a substrate stage with a pattern of a mask held on a mask stage, comprising:

    a stage apparatus according to Claim 6 is used as at least one of the mask stage and the substrate stage.

# FIG. 1

FIG. 2

FIG. 3

## FIG. 4A

## FIG. 4B

# FIG. 5

FIG. 6

| | | |
|---|---|---|
| 116, 118 — | Y INTERFEROMETER | → |
| 146, 148 — | X INTERFEROMETER | → |
| 16 — | RETICLE INTERFEROMETER | → |
| 64A, 64B — | ENCODER | → |
| 74A, 74B — | ROTARY ENCODER | → |
| SS — | SENSOR GROUP | → |
| | AF/AL SYSTEM | → |
| ALG — | ALIGNMENT SYSTEM | → |

MAIN CONTROL APPARATUS

→ X LINEAR MOTOR — XM1, XM2
→ Y LINEAR MOTOR — YM1, YM2

→ X AXIS FINE MOVEMENT MOTOR — VX
→ Z AXIS FINE MOVEMENT MOTOR — VZ1, VZ2
→ Y AXIS LINEAR MOTOR — LY1∼LY3

50

EP 1 688 988 A1

# FIG. 7A

# FIG. 7B

# FIG. 8

ACCELERATION    DECELERATION

X THRUST

INPUT TORQUE
(COUNTERCLOCKWISE +)

# FIG. 9

FIG. 10A

FIG. 10B

FIG. 10C

FIG. 11A

FIG. 11B

FIG. 11C

# FIG. 12A

# FIG. 12B

# FIG. 13

X THRUST

Fk

Fk

STEP　　　　　　EXPOSURE　　　　　　STEP

INPUT TORQUE
(COUNTERCLOCKWISE +)

T

t

STEP　　　　　　EXPOSURE　　　　　　STEP

EP 1 688 988 A1

## FIG. 14A

## FIG. 14B

# FIG. 15

201 — DESIGN
(FUNCTIONS, PERFORMANCE, AND PATTERN)

203 — WAFER
FABRICATION

202 — MASK CREATION

204 — WAFER
PROCESSING

205 — DEVICE
ASSEMBLY

206 — INSPECTION

(SHIPPING)

## INTERNATIONAL SEARCH REPORT

| International application No. |
| --- |
| PCT/JP2004/016584 |

**A. CLASSIFICATION OF SUBJECT MATTER**
Int.Cl$^7$ H01L21/027, G03F7/20

According to International Patent Classification (IPC) or to both national classification and IPC

**B. FIELDS SEARCHED**

Minimum documentation searched (classification system followed by classification symbols)
Int.Cl$^7$ H01L21/027, G03F7/20

Documentation searched other than minimum documentation to the extent that such documents are included in the fields searched

| Jitsuyo Shinan Koho | 1926–1996 | Toroku Jitsuyo Shinan Koho | 1994–2005 |
| Kokai Jitsuyo Shinan Koho | 1971–2005 | Jitsuyo Shinan Toroku Koho | 1996–2005 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2003-45785 A (Nikon Corp.), 14 February, 2003 (14.02.03), Full text; all drawings (Family: none) | 1-12 |
| A | JP 2002-175963 A (Nikon Corp.), 21 June, 2002 (21.06.02), Full text; all drawings (Family: none) | 1-12 |
| A | JP 2002-56102 A (ASM Lithography B.V.), 22 February, 2002 (22.02.02), Full text; all drawings & EP 1160628 A2 & KR 001110130 A & US 2002/0005939 A1 | 1-12 |

| ☒ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 23 February, 2005 (23.02.05) | 15 March, 2005 (15.03.05) |

| Name and mailing address of the ISA/ Japanese Patent Office | Authorized officer |
| --- | --- |
| Facsimile No. | Telephone No. |

Form PCT/ISA/210 (second sheet) (January 2004)

**INTERNATIONAL SEARCH REPORT**

International application No.

PCT/JP2004/016584

C (Continuation).    DOCUMENTS CONSIDERED TO BE RELEVANT

| Category* | Citation of document, with indication, where appropriate, of the relevant passages | Relevant to claim No. |
|---|---|---|
| A | JP 8-330224 A (Nikon Corp.), 13 December, 1996 (13.12.96), Full text; all drawings & US 5874820 A1         & US 6008500 A1 & US 6020710 A1         & US 6087797 A1 & US 6150787 A1         & US 6151105 A1 & US 6175404 B1         & US 6188195 B1 & US 6246202 B1 | 1-12 |
| A | JP 7-115054 A (Canon Inc.), 02 May, 1995 (02.05.95), Full text; all drawings (Family: none) | 1-12 |

Form PCT/ISA/210 (continuation of second sheet) (January 2004)